# EUROPEAN PATENT APPLICATION

(11) **EP 1 693 899 A2**
(43) Date of publication of application: **23.08.2006**
(21) Application number: 06003046.7
(22) Date of filing: 15.02.2006
(51) Int. Cl.: H01L 31/04, H01L 31/05, H01L 31/18

(54) **Solar cell, solar cell string and method of manufacturing solar cell string**

(30) Priority: 16.02.2005 JP 2005039555; 08.06.2005 JP 2005168124; 17.11.2005 JP 2005332580
(71) Applicant: SHARP KABUSHIKI KAISHA, Osaka-shi, Osaka 545-8522 (JP)
(72) Inventor: Takamoto, Tatsuya, Ikoma-gun, Nara 636-0821 (JP); Agui, Takaaki, Nara-shi, Nara 630-8101 (JP); Washio, Hidetoshi, Kashihara-shi, Nara 634-0006 (JP); Takahashi, Naoki, Soraku-gun, Kyoto 619-0216 (JP)
(74) Representative: Müller - Hoffmann & Partner

(57) **Abstract**

A solar cell (2, 2a, 2b) includes a first compound semiconductor stacked body (5a) with an n-type compound semiconductor layer and a p-type compound semiconductor layer in contact with each other, the first compound semiconductor stacked body (5a) has a first electrode (8a) of a first polarity and a second electrode (6a) of a second polarity, and surfaces of the first electrode (8a) and the second electrode (6a) are exposed to the same side. A solar cell string (1) using the solar cells (2, 2a, 2b) and a method of manufacturing the solar cell string (1) are further provided.

## Description

This nonprovisional application is based on Japanese Patent Applications Nos. 2005-039555, 2005-168124 and 2005-332580 filed with the Japan Patent Office on February 16, 2005, June 8, 2005 and November 17, 2005, respectively, the entire contents of which are hereby incorporated by reference.

### BACKGROUND OF THE INVENTION

### Field of the Invention

The present invention relates to a solar cell, a solar cell string and a method of manufacturing the solar cell string.

### Description of the Background Art

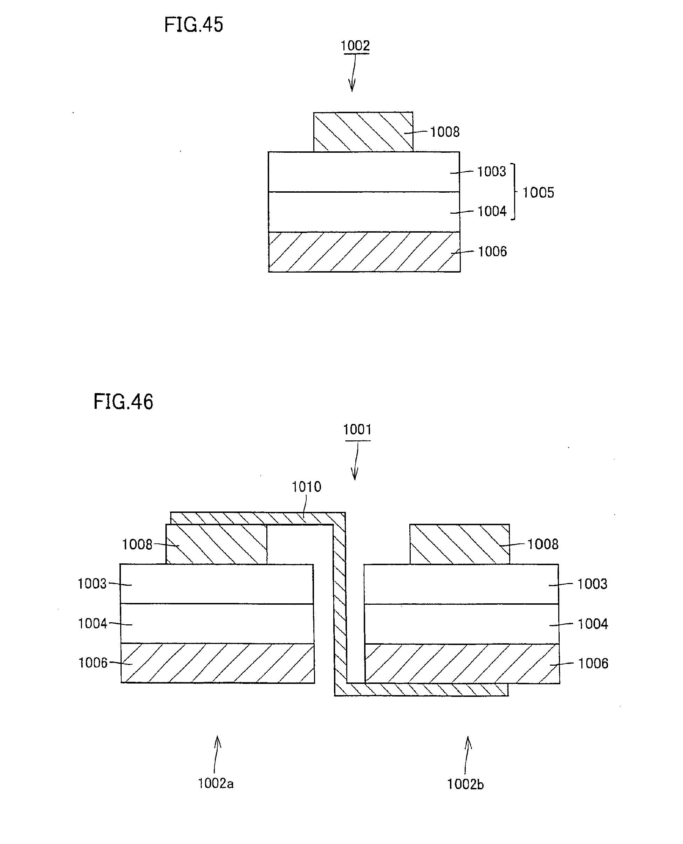

A solar cell using a compound semiconductor has been known as a solar cell having high efficiency and suitable for aerospace applications among solar cells. As shown in Fig. 45, a conventional solar cell 1002 employing a compound semiconductor includes a first compound semiconductor stacked body 1005 consisting of a semiconductor substrate 1004 and a compound semiconductor layer 1003 formed on semiconductor substrate 1004, a first electrode 1008 formed on a surface of compound semiconductor layer 1003 and a second electrode 1006 formed on semiconductor substrate 1004 (see, for example, United States Patent No. 6, 359, 210). Here, the first and second electrodes 1008 and 1006 have mutually different polarities, having either positive or negative polarity.

As shown in Fig. 46, the first electrode 1008 of a first solar cell 1002a is electrically connected to the second electrode 1006 of a second solar cell 1002b by a wiring member 1010 such as a silver (Ag) ribbon, and thus, a solar cell string 1001 is formed.

### SUMMARY OF THE INVENTION

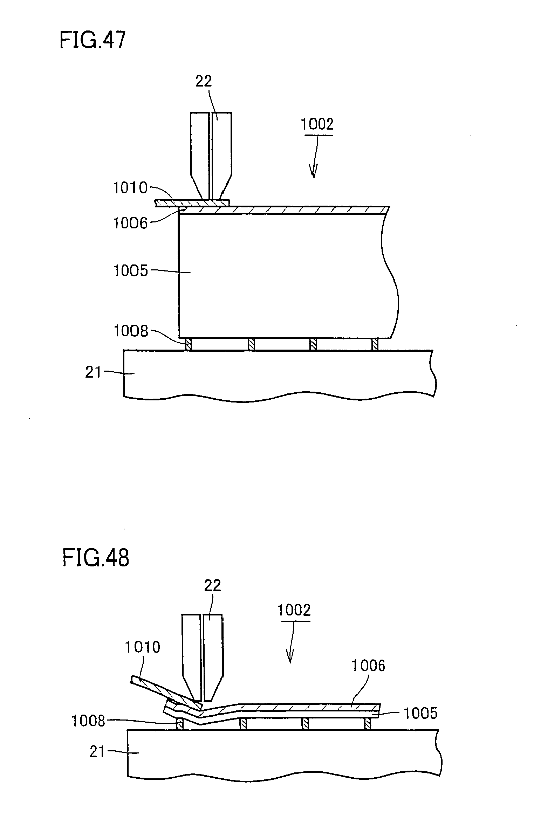

In conventional solar cell 1002, the first electrode 1008 is formed only on a part of compound semiconductor layer 1003, and therefore, the surface of solar cell 1002 comes to have recessed and protruded portions. When solar cell string 1001 is formed, solar cell 1002 is arranged on a stage 21 with the side of first electrode 1008, that is, the side with recesses and protrusions, facing downward, a wiring member 1010 is sandwiched between an electrode 22 for welding and the second electrode 1006, and weld and electrically connected, as shown in the schematic cross-section of Fig. 47. At this time, solar cell 1002 is pressed by electrode 22 for welding with the surface on the side of first electrode 1008 having recesses and protrusions positioned on the stage, and therefore, solar cell 1002 is prone to damage or cracking, as shown in the schematic cross-section of Fig. 48.

Therefore, an object of the present invention is to provide a solar cell less susceptible to damages and cracks generated at the time of connecting a wiring member, a solar cell string using such solar cells, and a method of manufacturing the solar cell string.

The present invention provides a solar cell including a fist compound semiconductor stacked body with an n-type compound semiconductor layer and a p-type compound semiconductor layer in contact with each other, wherein the first compound semiconductor stacked body has a first electrode of a first polarity and a second electrode of a second polarity, and surfaces of the first electrode and the second electrode are exposed to the same side.

The present invention also provides a solar cell string including a plurality of solar cells described above, wherein the second electrode of the first solar cell is electrically connected by a first wiring member to the first electrode of the second solar cell.

Further, the present invention provides a method of manufacturing a solar cell string by electrically connecting a plurality of solar cells described above to each other, including the steps of: placing the first and second solar cells on a stage with a side where a surface of the first electrode is exposed facing upward; electrically connecting one end of a first wiring member to the second electrode of the first solar cell; and electrically connecting the other end of the first wiring member to the first electrode of the second solar cell. In the method of manufacturing the solar cell string in accordance with the present invention, the order of performing the step of electrically connecting one end of the first wiring member to the second electrode of the first solar cell and the step of electrically connecting the other end of the first wiring member to the first electrode of the second solar cell is not specifically limited.

In the method of manufacturing the solar cell string, as the first wiring member, a metal ribbon or a metal wire may be used, and the first wiring member may be connected by welding or bonding.

Further, in the solar cell in accordance with the present invention, a second compound semiconductor stacked body including an n-type compound semiconductor layer and a p-type compound semiconductor layer in contact with each other is provided spaced from the first compound semiconductor stacked body, and a third electrode may be provided on a surface of the second compound semiconductor stacked body.

Further, the present invention provides a solar cell string including a plurality of solar cells described above, wherein the second electrode of the first solar cell is electrically connected by a first wiring member to the first electrode of the second solar batter, and the third electrode of the first solar cell is electrically connected by a second wiring member to the second electrode of the second solar cell.

The present invention further provides a method of manufacturing a solar cell string by electrically connecting a plurality of solar cells described above to each other, including the steps of: placing the first and second solar cells on a stage with a side
where a surface of the first electrode is exposed facing upward; electrically connecting one end of a first wiring member to the second electrode of the first solar cell; electrically connecting the other end of the first wiring member to the first electrode of the second solar cell; electrically connecting one end of a second wiring member to the third electrode of the first solar cell; and electrically connecting the other end of the second wiring member to the second electrode of the second solar cell. In the method of manufacturing the solar cell string in accordance with the present invention, the order of performing the step of electrically connecting one end of the first wiring member to the second electrode of the first solar cell, the step of electrically connecting the other end of the first wiring member to the first electrode of the second solar cell, the step of electrically connecting one end of a second wiring member to the third electrode of the first solar cell, and the step of electrically connecting the other end of the second wiring member to the second electrode of the second solar cell is not specifically limited.

Further, in the method manufacturing the solar cell string, a metal ribbon or a metal wire may be used as each of the first and second wiring members, and the first and second wiring members may be each connected by wilding or bonding.

Further, in the solar cell in accordance with the present invention, the first compound semiconductor stacked body may have a third electrode of which surface is exposed to a side opposite to the first and second electrodes.

Preferably, in the solar cell in accordance with the present invention, resistance between the second and third electrodes is at most 1 Ω.

Further, in the solar cell in accordance with the present invention, the third electrode is formed to have a lattice shape.

Further, in the solar cell in accordance with the present invention, the third electrode may be formed of a transparent conductive material.

The solar cell in accordance with the present invention may have a tunnel junction between the compound semiconductor layer on which the first electrode is formed and the compound semiconductor layer on which the second electrode is formed.

Preferably, in the solar cell in accordance with the present invention, the tunnel junction is formed at an interface between a compound semiconductor layer having different conductivity type from the compound semiconductor layer on which the second electrode is formed and the compound semiconductor layer on which the second electrode is formed.

In the present invention, provided that the first polarity of the first electrode and the second polarity of the second electrode are different from each other, the first polarity and the second polarity may be the positive or negative polarity.

In the present invention, the stage is not specifically limited, and any stage that has a surface allowing placement of the first and second solar cells may be used.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Figs. 1 to 6 are schematic cross-sections illustrating an exemplary method of manufacturing a solar cell in accordance with the present invention.
Fig. 7 is a schematic plan view of an example of the solar cell in accordance with the present invention.
Fig. 8 is a schematic cross-section taken along the line VIII-VIII of Fig. 7.
Fig. 9 is a schematic cross-section taken along the line IX-IX of Fig. 7.
Fig. 10 is a schematic plan view of an example of the solar cell string in accordance with the present invention.
Fig. 11 is a schematic cross-section take along the line XI-XI of Fig. 10.
Fig. 12 is a schematic cross-section take along the line XII-XII of Fig. 10.
Fig. 13 is a schematic plan view of another example of the solar cell string in accordance with the present invention.
Figs. 14 and 15 are schematic cross-sections illustrating an example of a method of manufacturing the solar cell string in accordance with the present invention.
Figs. 16 to 19 are schematic cross-sections illustrating another example of the method of manufacturing the solar cell in accordance with the present invention.
Figs. 20 to 23 are schematic cross-sections of another example of the solar cell in accordance with the present invention.
Figs. 24 to 27 are schematic cross-sections illustrating a further example of the method of manufacturing the solar cell in accordance with the present invention.
Figs. 28 to 34 are schematic cross-sections showing a further example of the solar cell in accordance with the present invention.
Figs. 35 to 40 are schematic cross-sections illustrating a further example of the method of manufacturing the solar cell in accordance with the present invention.
Figs. 41 to 44 are schematic cross-sections of a further example of the solar cell in accordance with the present invention.
Fig. 45 is a schematic cross-section of a conventional solar cell.
Fig. 46 is a schematic cross-section of a conventional solar cell string.
Figs. 47 and 48 are schematic cross-sections illustrating an example of a method of manufacturing the conventional solar cell string.

### DESCRIPTION OF THE PREFERRED EMBODIMENTS

In the following, embodiments of the present invention will be described. In the figures of the invention, the same or corresponding reference characters denote the same or corresponding portions.

### (First Embodiment)

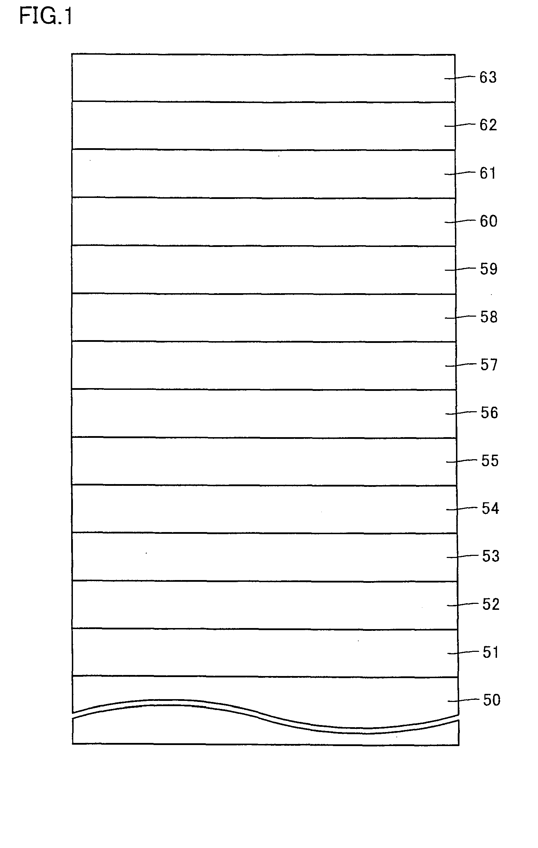

An example of the method of manufacturing the solar cell in accordance with the present invention will be described in the following. First, as shown in the schematic cross-section of Fig. 1, on a surface of an n-type GaAs substrate 50, an n-type InGaP layer 51, an n-type GaAs layer 52, an n-type AlInP layer 53, an n-type InGaP layer 54, a p-type InGaP layer 55, a p-type AlInP layer 56, a p-type AlGaAs layer 57, an n-type InGaP layer 58, an n-type AlInP layer 59, an n-type GaAs layer 60, a p-type GaAs layer 61, a p-type InGaP layer 62 and a p-type GaAs layer 63 are formed successively by, for example, MOCVD (Metal Organic Chemical Vapor Depositon) method. Here, p-type AlGaAs layer 57 and n-type InGaP layer 58 form a tunnel junction.

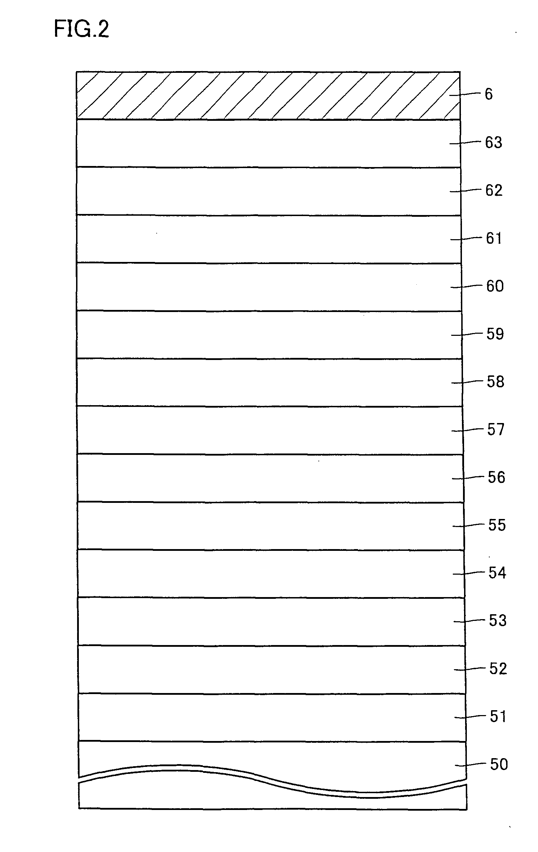

Next, as shown in the schematic cross-section of Fig. 2, on a surface of p-type GaAs layer 63, a back surface electrode layer 6 is formed. Here, back surface electrode layer 6 is formed on the entire surface of p-type GaAs layer 63, and the surface of back surface electrode layer 6 is flat.

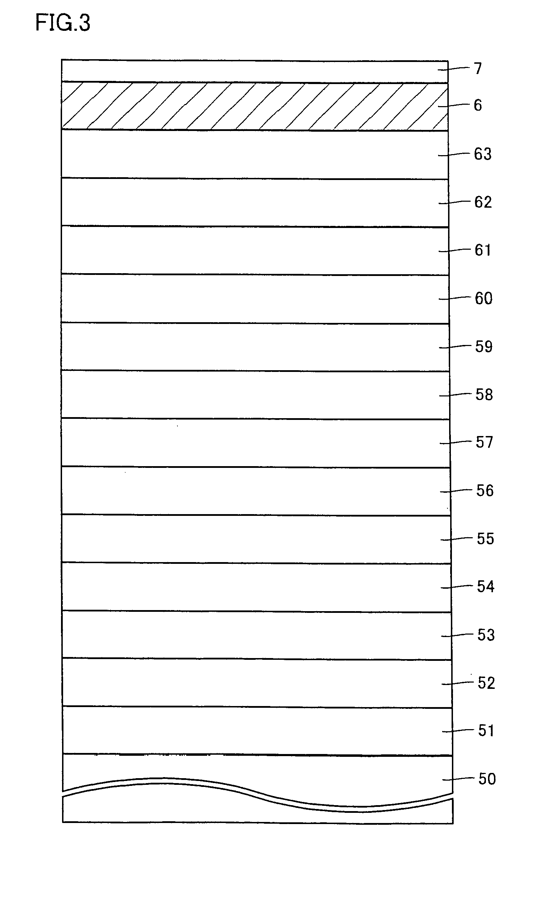

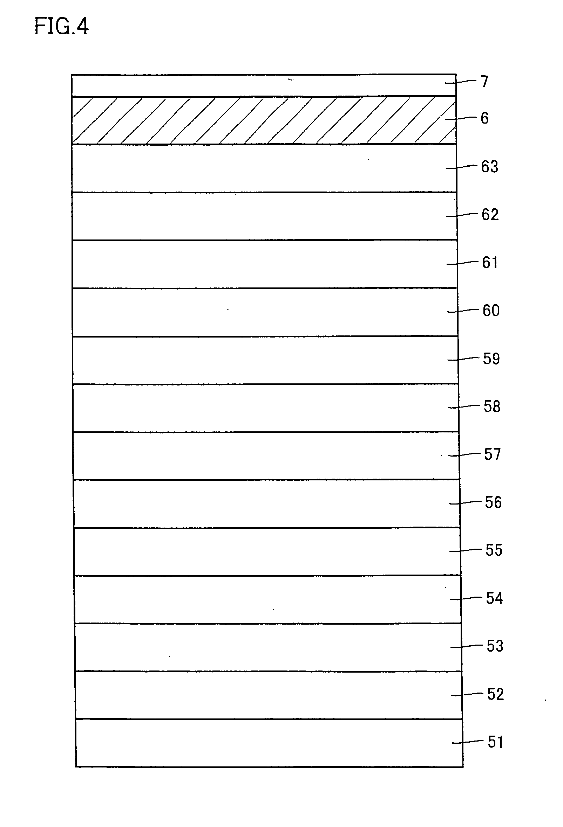

Next, as shown in the schematic cross-section of Fig. 3, wax 7 is applied to the entire surface of back surface electrode layer 6. In this state, n-type GaAs substrate 50 is dipped in an alkali solution such as ammonia water, so that n-type GaAs substrate 50 is removed by etching and a surface of n-type InGaP layer 51 is exposed, as shown in the schematic cross-section of Fig. 4.

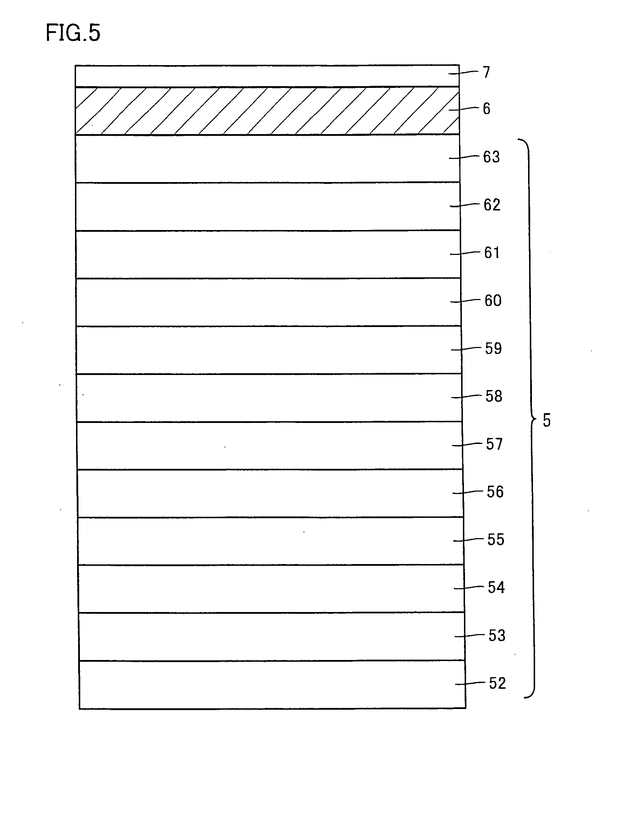

Thereafter, n-type InGaP layer 51 is removed by etching using an acid solution, to expose a surface of n-type GaAs layer 52 as shown in the schematic cross-section of Fig. 5. In this manner, a compound semiconductor stacked body 5 is formed. Here, in compound semiconductor stacked body 5, by successively forming compound semiconductor layers such that band gap becomes narrower from the side where the sunlight enters toward the opposite side, sunlight of prescribed wavelength can successively be absorbed in correspondence to the band gap, and therefore, conversion efficiency of the solar cell and the solar cell string of the present invention can be improved.

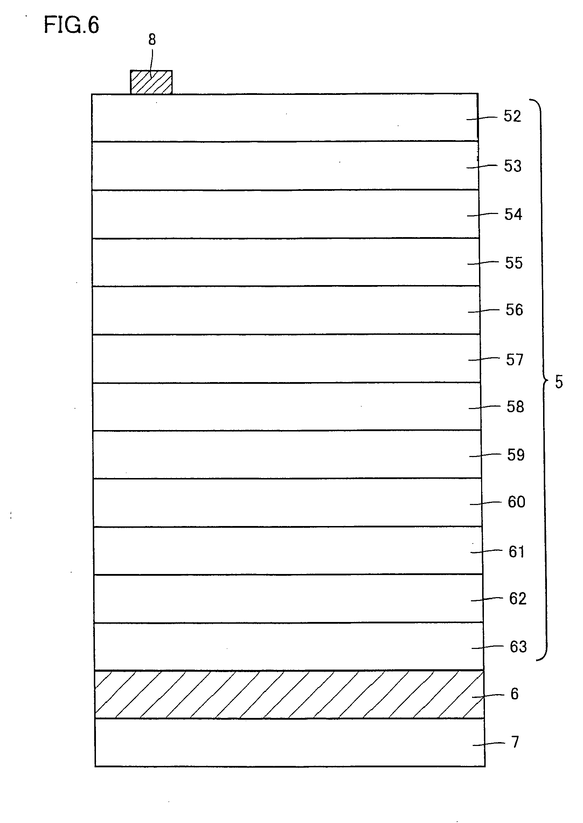

Next, on a surface of a part of n-type GaAs layer 52, a resist pattern is formed by photolithography, and thereafter, a metal film is formed and the resist pattern is removed, whereby a surface electrode layer 8 is formed in a prescribed pattern as shown in the schematic cross-section of Fig. 6. Thereafter, wax 7 is removed.

Then, using surface electrode layer 8 as a mask, n-type GaAs layer 52 at portions where surface electrode layer 8 is not formed is removed by etching using an alkali solution. Next, a resist pattern is formed by photolithography or the like to cover surface electrode layer 8, and by etching using an alkali solution and etching using an acid solution, a part of the surface of back surface electrode layer 6 is exposed. As a result, compound semiconductor stacked body 5 on the surface of back surface electrode layer 6 is divided into a plurality of pieces. Thereafter, an anti-reflection film may be formed on a surface where surface electrode layer 8 is formed, by EB (Electron Beam) vapor deposition or other method.

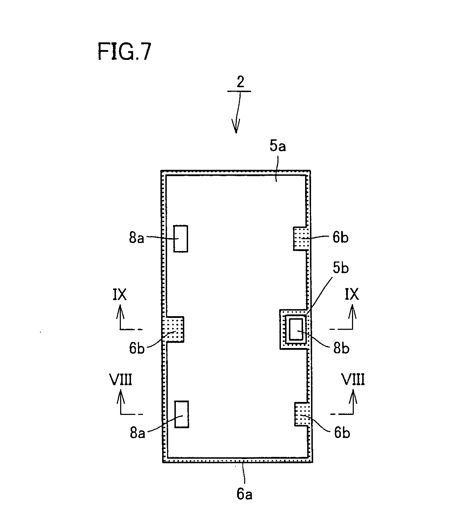

Then, by cutting and dividing the exposed back surface electrode layer 6 into a plurality of pieces, a plurality of solar cells 2 shown in the schematic plan view of Fig. 7 are formed.

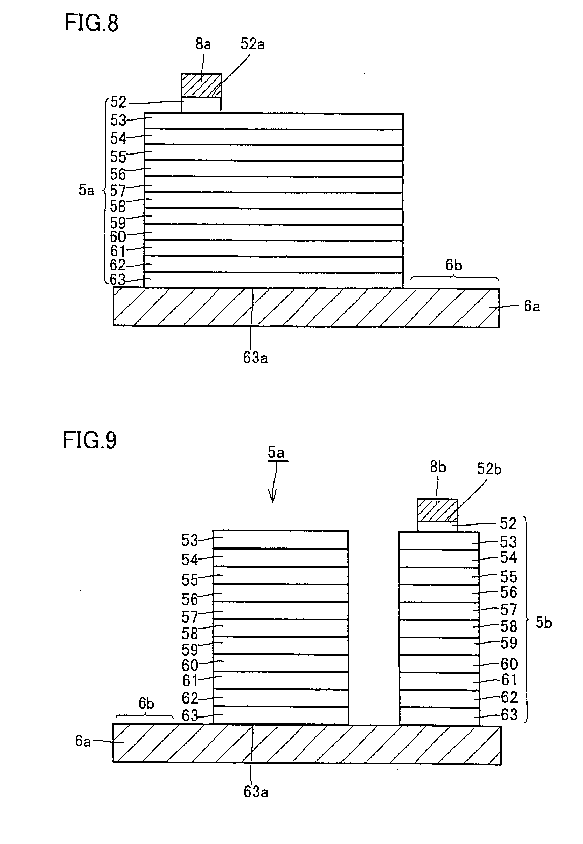

The structure of the solar cell in accordance with the present invention formed in the above-described manner will be described. Fig. 8 shows a schematic cross-section taken along the line VIII-VIII of Fig. 7, and Fig. 9 shows a schematic cross-section take along the line IX-IX of Fig. 7.

As shown in Fig. 7, in one solar cell 2 formed in the above-described manner, on a surface of a second electrode 6a formed by the division of back surface electrode layer 6, a first compound semiconductor stacked body 5a and a second semiconductor stacked body 5b formed by the division of compound semiconductor staked body 5 are formed spaced apart from each other.

As shown in Fig. 8, on a first surface 52a as one surface of the first compound semiconductor stacked body 5a, a first electrode 8a of a first polarity is formed, and on a second surface 63 a that is the surface opposite to the first surface 52a of the first compound semiconductor stacked body 5a, a second electrode 6a of a second polarity is formed. The surface of first electrode 8a and the surface of second electrode 6a are exposed to the same side (upper side of the sheet of Fig. 8).

In the present embodiment, the first electrode 8a is formed on the surface of n-type compound semiconductor layer, and the second electrode 6a is formed on the surface of p-type compound semiconductor layer, and therefore, the first polarity is negative and the second polarity is positive.

The first electrode has the same structure as surface electrode layer 8 described above, and the second electrode 6a has the same structure as back surface electrode layer 6 described above.

In the first compound semiconductor stacked body 5a, n-type GaAs layer 60 as the n-type compound semiconductor layer and p-type GaAs layer 61 as the p-type compound semiconductor layer are in contact with each other. Further, in the first compound semiconductor stacked body 5a, n-type InGaP layer 54 as the n-type compound semiconductor layer and p-type InGaP layer 55 as the p-type compound semiconductor layer are in contact with each other.

Further, as shown in Fig. 9, the second compound semiconductor stacked body 5b is formed spaced at a distance from the first compound semiconductor stacked body 5a, and on the surface 52b of second compound semiconductor stacked body 5b exposed to the same side as the first surface of the first compound semiconductor stacked body 5a, a third electrode 8b is provided.

In the second compound semiconductor stacked body 5b, n-type GaAs layer 60 as the n-type compound semiconductor layer and p-type GaAs layer 61 as the p-type compound semiconductor layer are in contact with each other. Further, in the second compound semiconductor stacked body 5b, n-type InGaP layer 54 as the n-type compound semiconductor layer and p-type InGaP layer 55 as the p-type compound semiconductor layer are in contact with each other.

With the solar cell of the present invention having such a structure, the wiring member can be electrically connected with the flat surface of second electrode 6a placed on the stage. Therefore, even when the first and second solar cells 2a and 2b are pressed by the electrode for welding at the time of connection, damage or crack of the first and second solar cells can be suppressed as compared with the conventional example.

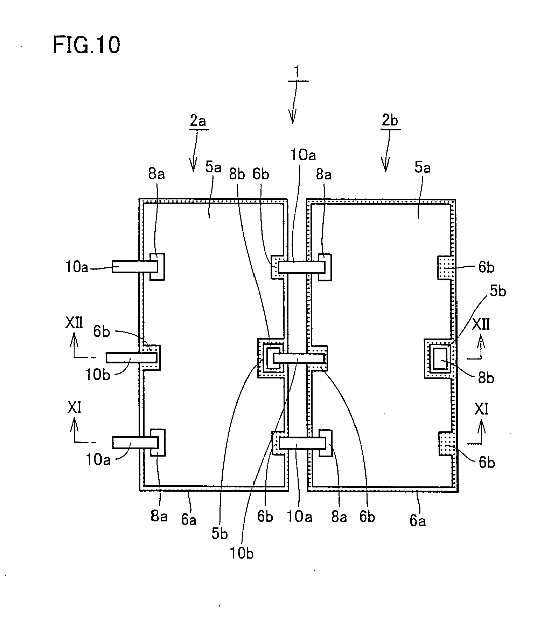

Fig. 10 is a schematic plan view of an example of a solar cell string in accordance with the present invention, in which a plurality of solar cells of the present invention manufactured in the above-described manner are electrically connected.

Here, a solar cell string 1 in accordance with the present invention includes first and second solar cells 2a and 2b manufactured in the above-described manner. An exposed portion 6b of the second electrode 6a of the first solar cell 2a is electrically connected by a first wiring member 10a to a first electrode 8a of the second solar cell 2b. Further, a third electrode 8b of the first solar cell 2a is electrically connected by a second wiring member 10b to the exposed portion 6b of the second electrode 6a of the second solar cell 2b.

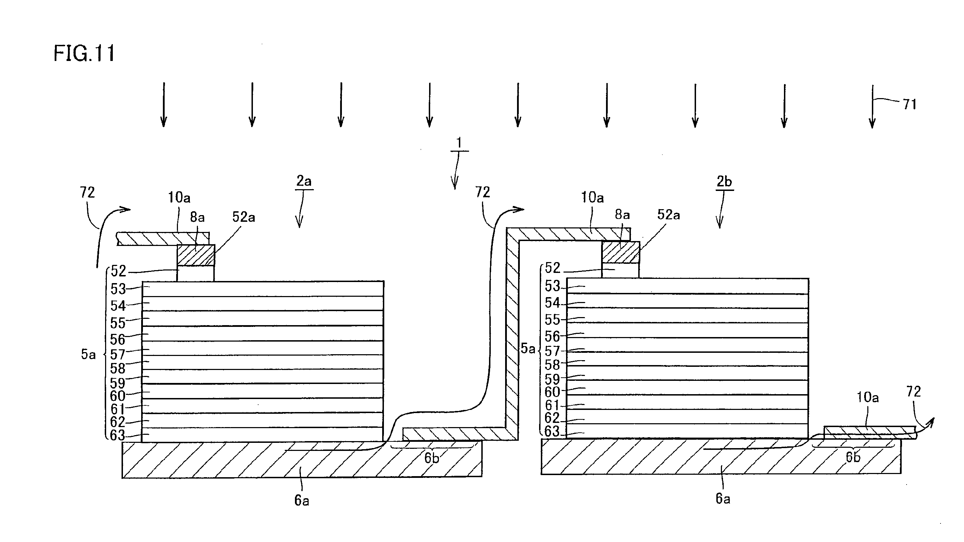

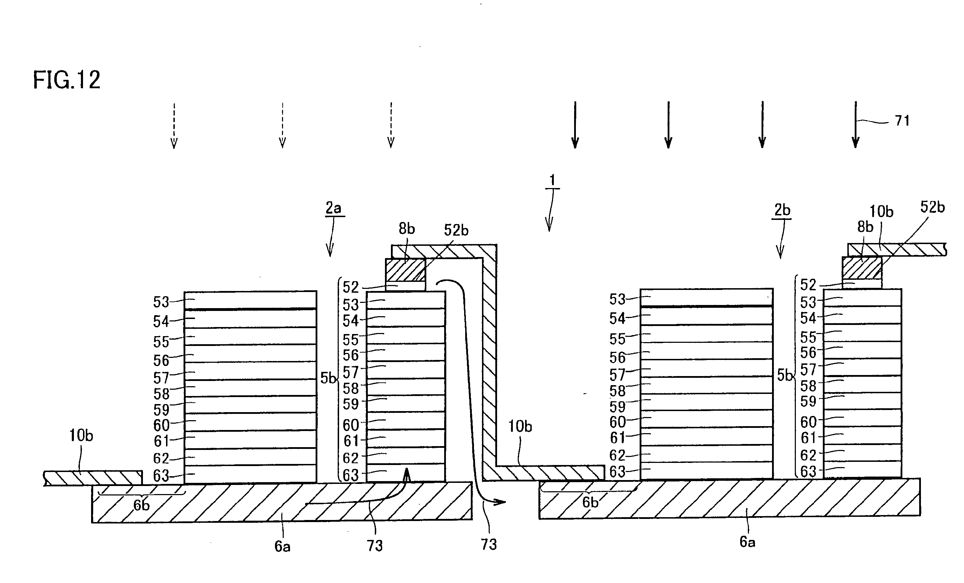

Fig. 11 shows a schematic cross-section taken along the line XI-XI of Fig. 10, and Fig. 12 shows a schematic cross-section taken along the line XII-XII of Fig. 10. As shown in Fig. 11, when solar cell string 1 is irradiated with sunlight 71, a current flows in the direction of an arrow 72 at portions electrically connected by the first wiring member 10a.

Generally, in a solar cell string having a plurality of solar cells electrically connected to each other, it is possible that part of the solar cells forming the solar cell string is shaded, when clouds hide the sun. In such a case, to a solar cell not irradiated with sunlight, a photovoltaic voltage generated in another solar cell might be applied in reverse direction, destroying the solar cell not irradiated with sunlight.

In the solar cell string of the present invention shown in Fig. 10, however, even when solar cell 2a, for example, is shaded, the current flows as shown by an arrow 73 of Fig. 12 in the solar cell 2a not irradiated with sunlight. Specifically, the current flows through the second semiconductor stacked body 5b to an adjacent solar cell 2b, and therefore, destruction of solar cell 2a not irradiated with sunlight can be prevented.

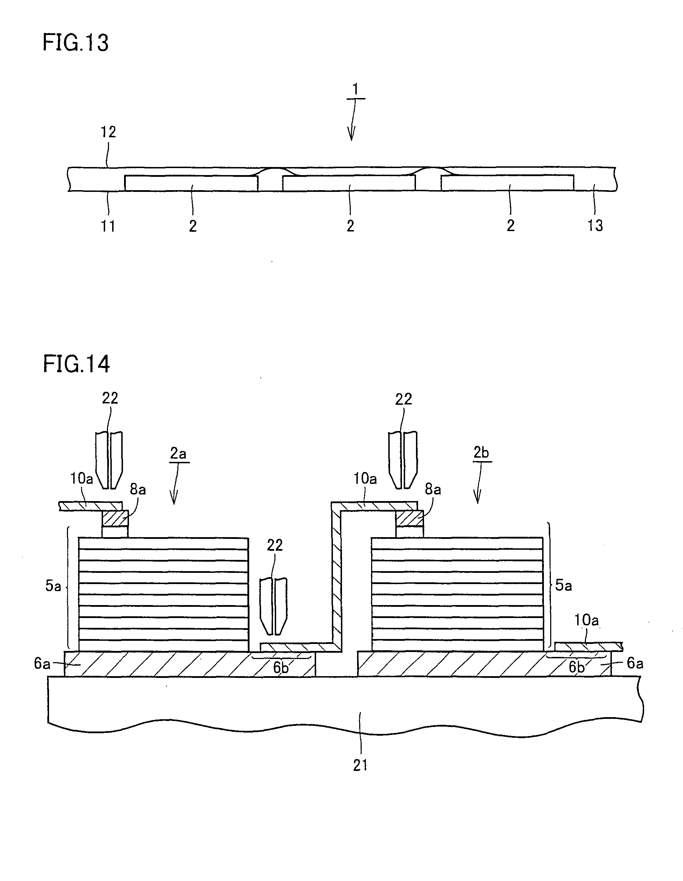

The solar cell string 1 of the present invention may be inserted, together with a transparent adhesive 13, between a transparent film 12 and a film 11, as shown in the schematic cross-section of Fig. 13. As transparent adhesive 13, an epoxy-based, silicone-based or acrylic adhesive may be used.

An example of the method of manufacturing the solar cell string in accordance with the present invention will be described in the following.

First, as shown in the schematic cross-section of Fig. 14, first and second solar cells 2a and 2b are placed on a stage 21 with the side where the surface of first electrode 8a is exposed facing upward.

Next, one end of first wiring member 10a is arranged on a surface of exposed portion 6b of the second electrode 6a of first solar cell 2a, sandwiched between electrode 22 for welding and exposed portion 6b, and welded to be electrically connected. The other end of first wiring member 10a is arranged on a surface of first electrode 8a of the first compound semiconductor stacked body 5a of second solar cell 2b, sandwiched between electrode 22 for welding and first electrode 8a, and welded to be electrically connected.

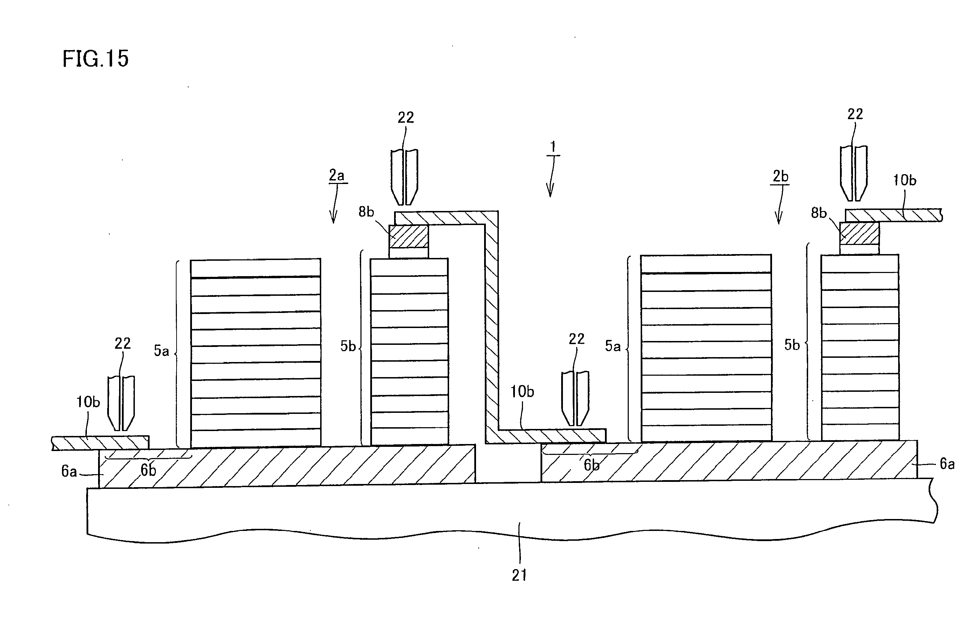

As shown in the schematic cross-section of Fig. 15, one end of a second wiring member 10b is arranged on a surface of third electrode 8b of the second semiconductor stacked body 5b of first solar cell 2a, sandwiched between electrode 22 for welding and third electrode 8b, and welded to be electrically connected. Further, the other end of second wiring member 10b is arranged on a surface of the exposed portion 6b of second electrode 6a of second solar cell 2b, sandwiched between electrode 22 for welding and exposed portion 6b, and welded to be electrically connected.

As described above, in the present invention, both the first and second wiring members 10a and 10b can be electrically connected in a state in which the flat surface of second electrode 6a is placed on stage 21. Therefore, even when the first and second solar cells 2a and 2b are pressed by electrode 22 for welding at the time of connection of the first and second wiring members 10a and 10b, damage or crack of the first and second solar cells can be suppressed as compared with the conventional example. Therefore, in the present invention, generation of cracks or any damage to the solar cells when the first and second wiring members 10a and 10b are connected can be reduced as compared with the conventional method.

The first and second wiring members may be connected by welding and, alternatively, these may be connected by bonding, as is well known conventionally.

As the first and second wiring members, a metal ribbon or metal wire formed of silver (Ag), gold (Au), copper (Cu) coated with gold or copper coated with silver may be used. When a metal wire is used as the first and second wiring members, a plurality of metal wires may be connected utilizing ultrasonic wave other than welding, and preferable material is silver. Preferable diameter of the metal wire is at most 25 µm.

Further, in the present invention, the number of junctions between the n-type and p-type compound semiconductor layers is not specifically limited.

In the present invention, as the first, second and third electrodes, a non-transparent material such as metal, or a transparent conductive material such as ZnO (zinc oxide), SnO₂ (tin oxide) or ITO (indium tin oxide) may be used.

### (Second Embodiment)

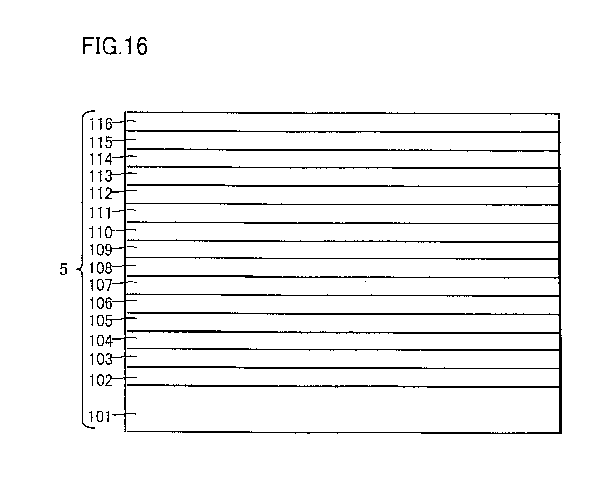

Another example of the method of manufacturing the solar cell in accordance with the present invention will be described in the following. First, as shown in the schematic cross-section of Fig. 16, on a surface of a p-type Ge substrate 101, an n-type Ge layer 102, an n-type GaAs layer 103, an n-type InGaP layer 104, a p-type AlGaAs layer 105, a p-type InGaP layer 106, a p-type GaAs layer 107, an n-type GaAs layer 108, an n-type AlInP layer 109, an n-type InGaP layer 110, a p-type AlGaAs layer 111, a p-type AlInP layer 112, a p-type InGaP layer 113, an n-type InGaP layer 114, an n-type AlInP layer 115 and an n-type GaAs layer 116 are formed successively. Thus, compound semiconductor stacked body 5 is formed. Here, n-type InGaP layer 104 and p-type AlGaAs layer 105 form a tunnel junction. Further, n-type InGaP layer 110 and p-type AlGaAs layer 111 form a tunnel junction.

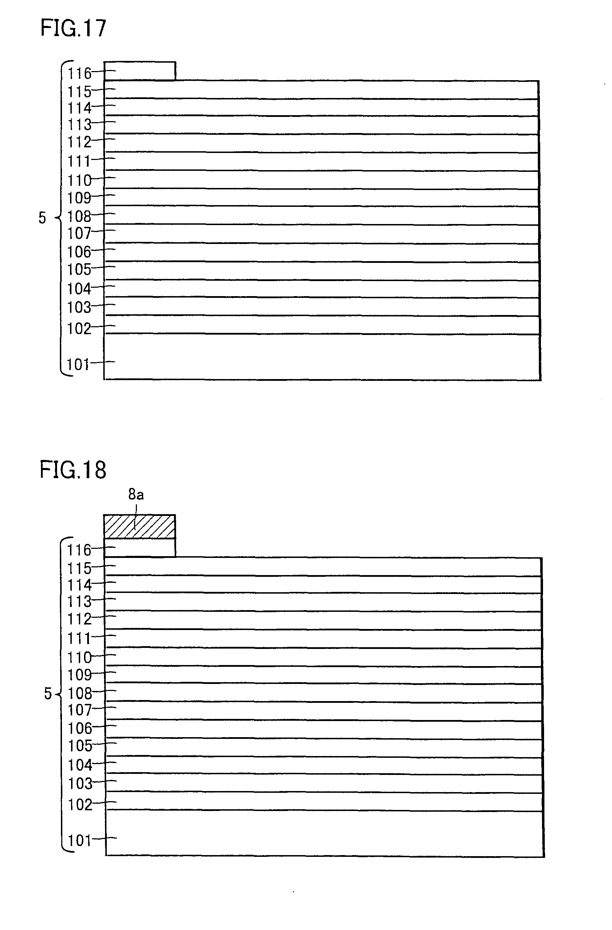

Next, as shown by the schematic cross-section of Fig. 17, a part of the n-type GaAs layer 116 is removed to a prescribed pattern by etching using an alkali solution. Then, as shown in the schematic cross-section of Fig. 18, on a surface of the remaining n-type GaAs layer 116, a first electrode 8a is formed.

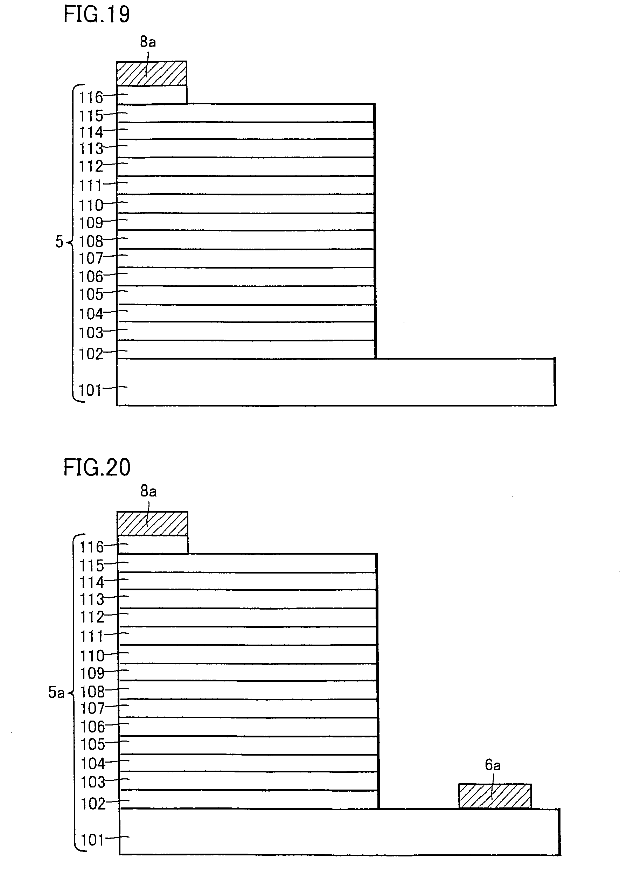

Next, by etching using an alkali solution and etching using an acid solution, a part of compound semiconductor stacked body 5 is removed to a prescribed pattern, and a surface of p-type Ge substrate 101 is exposed as shown in the schematic cross-section of Fig. 19. At this time, compound semiconductor stacked body 5 is divided into a plurality of pieces on the surface of p-type Ge substrate 101. Further, an anti-reflection film may be formed on a surface of n-type AlInP layer 115.

Then, as shown in the schematic cross-section of Fig. 20, on an exposed surface of p-type Ge substrate 101, a second electrode 6a is formed. Thereafter, the exposed p-type Ge substrate 101 is cut and divided into a plurality of pieces, whereby a plurality of solar cells of the present invention having the first compound semiconductor stacked body 5a shown in Fig. 20 are formed.

In the solar cell formed in this manner, on the surface of n-type GaAs layer 116 of first compound semiconductor stacked body 5a, the first electrode 8a having the first polarity is formed, and on the surface of p-type Ge substrate 101, the second electrode 6a having the second polarity is formed. The surface of first electrode 8a and the surface of second electrode 6a are exposed to the same side (upper side of the sheet of Fig. 20).

In the present embodiment, the first electrode 8a is formed on the surface of n-type compound semiconductor layer, and the second electrode 6a is formed on the surface of p-type compound semiconductor layer, and therefore, the first polarity is negative and the second polarity is positive.

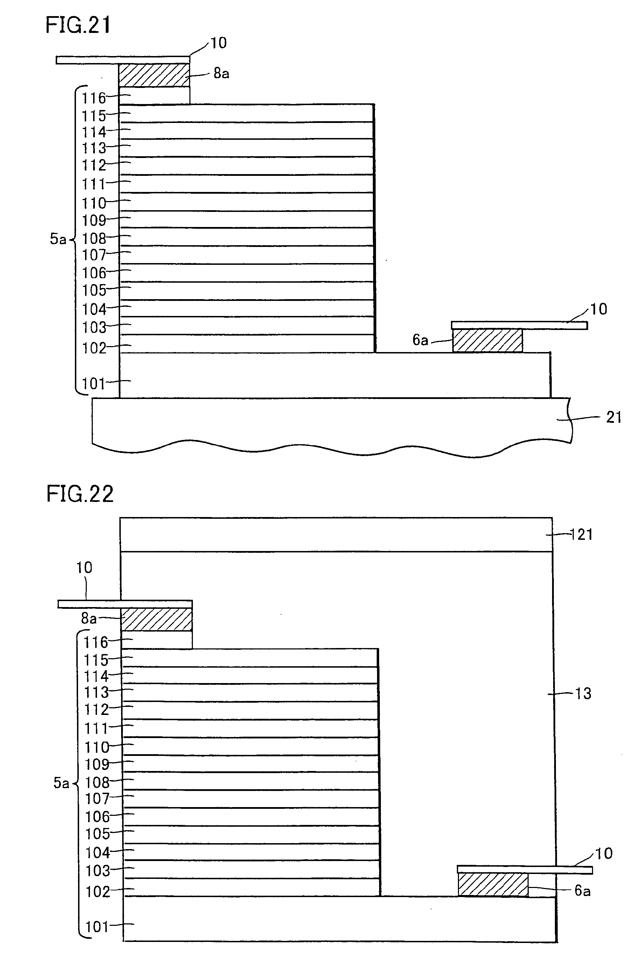

In the solar cell of the present invention having such a structure, wiring member 10 can be electrically connected to the first and second electrodes 8a and 6a, with the flat surface of p-type Ge substrate 101 placed on stage 21, as shown in the schematic cross-section of Fig. 21. Therefore, even when the solar cells of the present invention are pressed by the electrode for welding at the time of connection of wiring member 10, damage or crack of the solar cells of the present invention can be suppressed as compared with the conventional example.

As shown in the schematic cross-section of Fig. 22, transparent adhesive 13 may be applied to the surface on the sunlight entering side of the solar cell of the present invention, and a transparent protective member 121 may be adhered. Here, as transparent protective member 121, by way of example, glass or high polymer materials may be used. Examples of the high polymer materials used as the transparent protective member include polyamide, polycarbonate, polyacetal, polybutylene terephthalate, fluoroplastic, polyphenylene ether, polyethylene terephthalate, polyphenylene sulfide, polyester elastomer, polysulfone, polyether ether ketone, polyether imide, polyamide imide, polyimide and silicone resin.

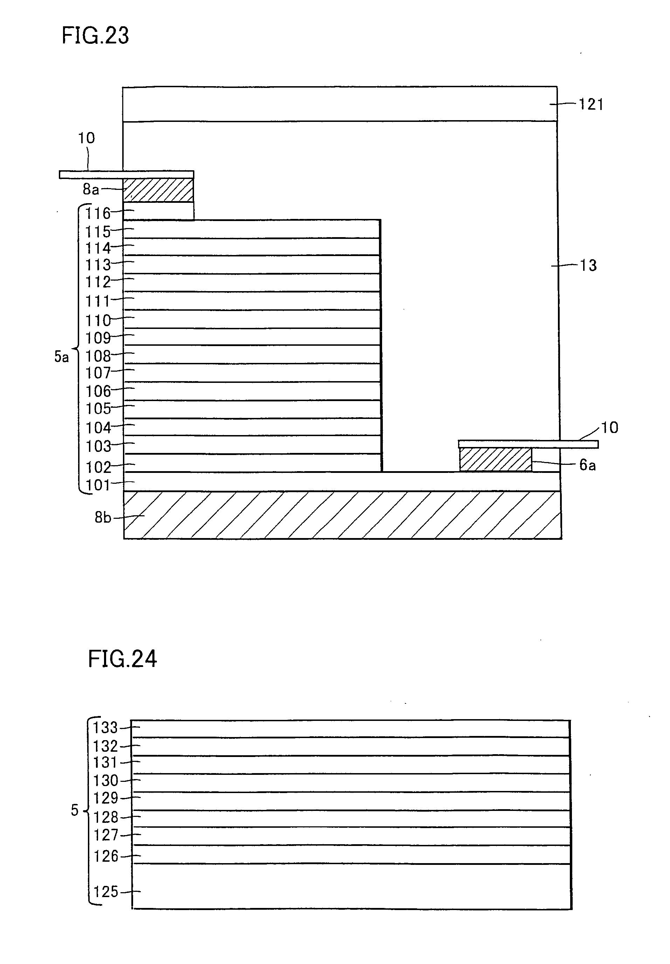

Thereafter, the surface of transparent protective member 121 is covered with a resist, and the thickness of p-type Ge substrate 101 1 is decreased by etching using a hydrofluoric acid-based etchant. Then, as shown in the schematic cross-section of Fig. 23, on a surface of p-type Ge substrate 101, a third electrode 8b may be formed.

Here, resistance between the second electrode 6a and the third electrode 8b is, preferably, at most 1 Ω. The second electrode 6a is provided for decreasing spreading resistance and to uniformly collect the current. Therefore, when both of the second and third electrodes 6a and 8b form an ohmic contact with the surface of p-type Ge substrate 101, the second and third electrodes 6a and 8b are conducted. In addition, when the resistance between the second and third electrodes 6a and 8b is not higher than 1 Ω, the current that can be taken out from the second electrode 6a would be taken out only from wiring member 10 formed at the third electrode 8b, without the necessity of providing any wire to the second electrode 6a.

### (Third Embodiment)

Another example of the method of manufacturing a solar cell in accordance with the present invention will be described in the following. First, as shown in the schematic cross-section of Fig. 24, on a p-type Ge substrate 125, a p-type GaAs layer 126, a p-type InGaP layer 127, a p-type AlGaAs layer 128, a p-type AlInP layer 129, a p-type InGaP layer 130, an n-type InGaP layer 131, an n-type AlInP layer 132 and an n-type GaAs layer 133 are formed successively.

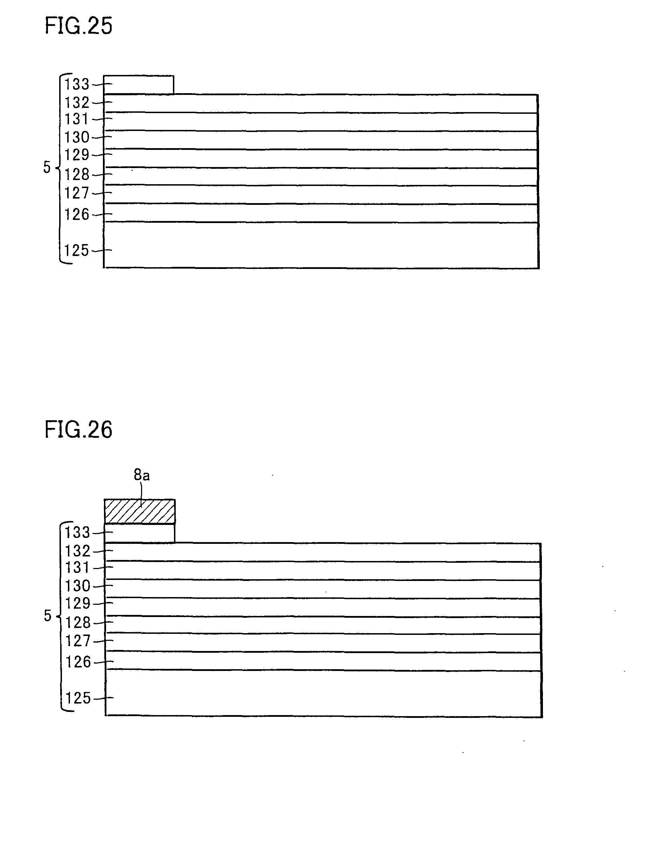

Thereafter, as shown in the schematic cross-section of Fig. 25, a part of n-type GaAs layer 133 is removed to a prescribed pattern by etching with an alkali solution. Then, as shown in the schematic cross-section of Fig. 26, on a surface of remaining n-type GaAs layer 133, the first electrode 8a is formed.

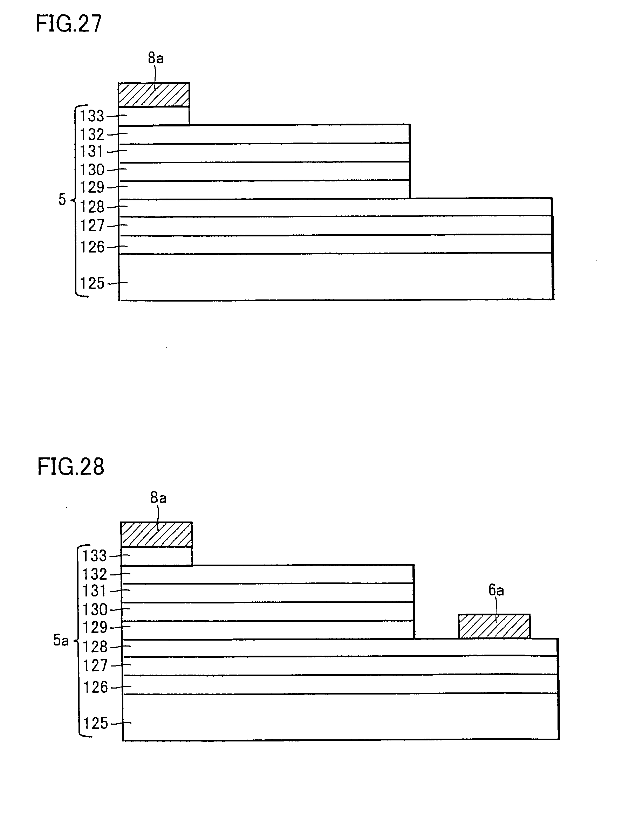

Thereafter, by etching using an alkali solution and etching using an acid solution, a part of compound semiconductor stacked body 5 is removed to a prescribed pattern, and as shown in the schematic cross-section of Fig. 27, a surface of p-type AlGaAs layer 128 is exposed. Thereafter, an anti-reflection film may further be formed on surfaces of n-type AlInP layer 132 and p-type AlGaAs layer 128.

Then, as shown in the schematic cross-section of Fig. 28, on the exposed surface of p-type AlGaAs layer 128, the second electrode 6a is formed. Thereafter, a wafer including compound semiconductor stacked body 5 and back surface electrode layer 6 is cut and divided into a plurality of pieces, so that compound semiconductor stacked body 5 described above is divided, and a plurality of solar cells of the present invention having the first compound semiconductor stacked body 5a shown in Fig. 28 are obtained.

In the solar cell of the present invention formed in this manner, on the surface of n-type GaAs layer 133 of the first compound semiconductor stacked body 5a, the first electrode 8a is formed, and on the surface of p-type Ge substrate 125, the second electrode 6a is formed. The surfaces of the first and second electrodes 8a and 6a are exposed to the same side (upper side of the sheet of Fig. 28).

In the present embodiment, the first electrode 8a is formed on the surface of the n-type compound semiconductor layer, and the second electrode 6a is formed on the surface of the p-type compound semiconductor layer, and therefore, the first polarity is negative and the second polarity is positive.

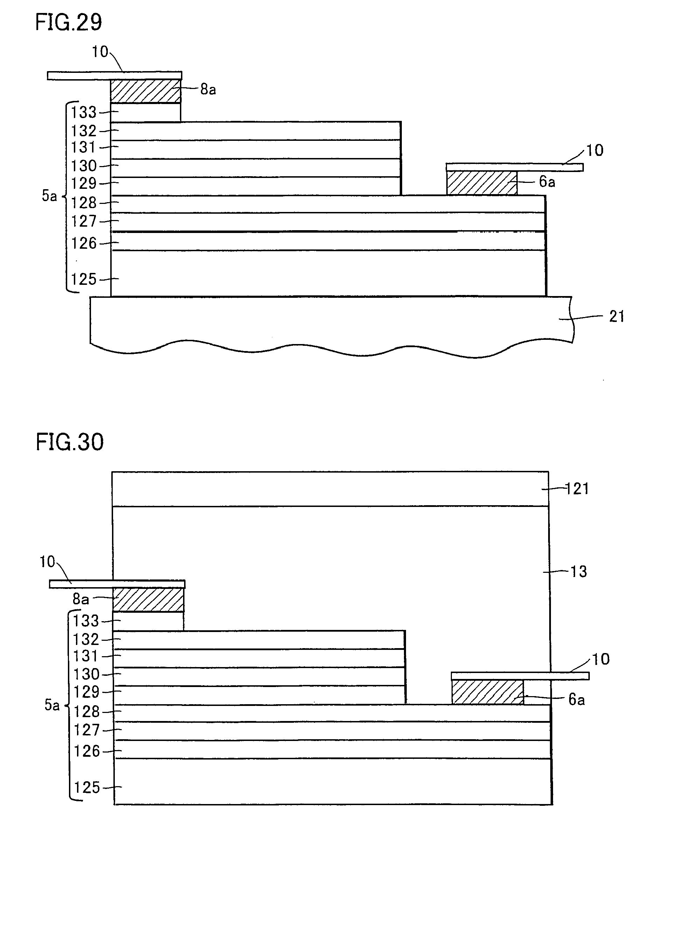

In the solar cell in accordance with the present invention having such a structure, wiring member 10 can be electrically connected to the first and second electrodes 8a and 6a with the flat surface of p-type Ge substrate 125 placed on stage 21, as shown in the schematic cross-section of Fig. 29. Therefore, even when the solar cell of the present invention is pressed by the electrode for welding at the time of connecting wiring member 10, damage or crack of the solar cell of the present invention can be suppressed as compared with the conventional example.

Further, as shown in the schematic cross-section of Fig. 30, transparent adhesive 13 may be applied to a surface on the side where the sunlight enters of the solar cell of the present invention and transparent protective member 121 may be adhered,

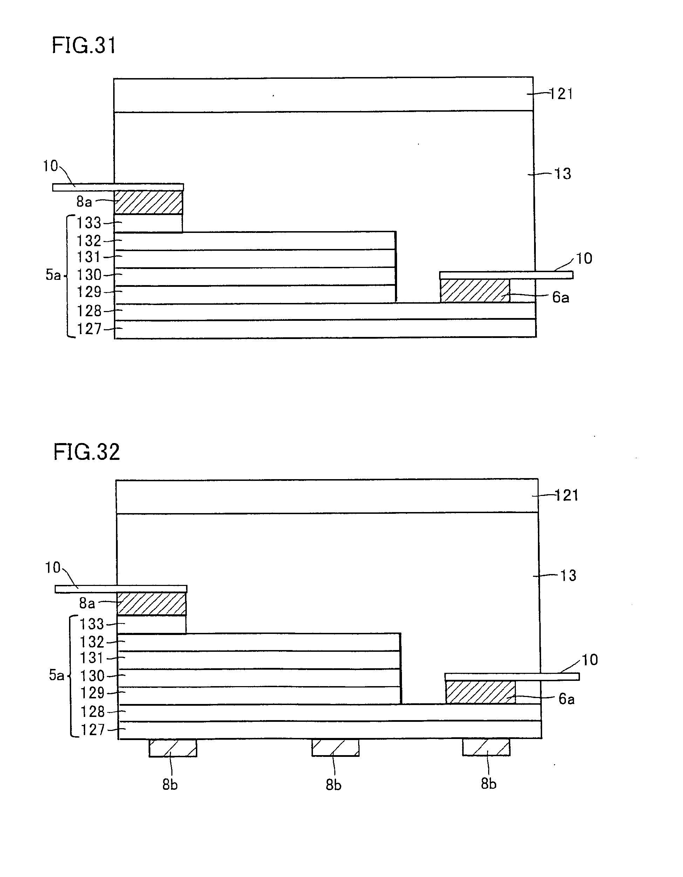

Thereafter, the surface of transparent protective member 121 is covered with a resist, p-type Ge substrate 125 and p-type GaAs layer 126 are removed by etching using a hydrofluoric acid-based etchant, the surface of p-type InGaP layer 127 is exposed and the etching is stopped, as shown in the schematic cross-section of Fig. 31. Then, as shown in the schematic cross-section of Fig. 32, on the exposed surface of p-type InGaP layer 127, the third electrode 8b patterned in a lattice shape is formed using, for example, a metal mask.

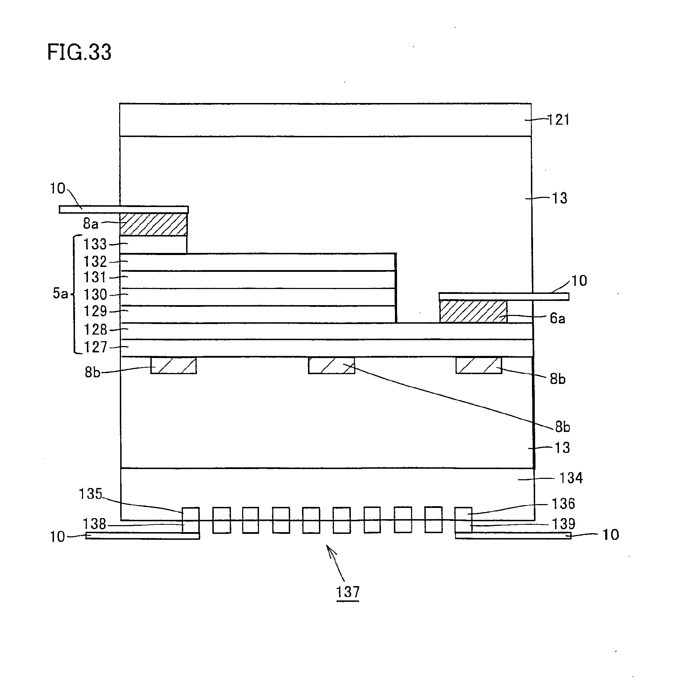

Thereafter, as show in the schematic cross-section of Fig. 33, transparent adhesive 13 may be applied to that surface of the first compound semiconductor layer 5a on which the third electrode 8b is formed, and a back electrode type solar cell 137 having n-type impurity diffused Si layer 135 and p-type impurity diffused Si layer 136 formed on the surface of n-type Si substrate 134 opposite to the side where the sunlight enters alternately may be adhered.

Here, on the surface of n-type impurity diffused Si layer 135, an n-type electrode 138 is formed, and on the surface of p-type impurity diffused Si layer 136, a p-type electrode 139 is formed. Further, on the surfaces of n-type electrode 138 and p-type electrode 139, wiring member 10 is electrically connected.

In such a structure, Si (band gap: 1.12eV) forming the n-type impurity diffused Si layer 135 and p-type impurity diffused Si layer 136 of the back electrode type solar cell 137 has narrower band gap than InGaP (band gap: 1.85eV) forming the p-type InGaP layer 130 and n-type InGaP layer 131 of the solar cell using the compound semiconductor, and therefore, sunlight of such a wavelength that cannot be absorbed by the solar cell using the compound semiconductor can be absorbed by the back electrode type solar cell 137.

Here, if the third electrode 8b is formed of a non-transparent material, it is preferred that the third electrode 8b covers at most 30% of the area of the surface where the third electrode 8b is formed, in order to allow entrance of larger amount of sunlight to the back electrode type solar cell 137. If the third electrode 8b is formed of a transparent conductive material, larger amount of sunlight can enter the back electrode type solar cell 137 than when the third electrode 8b is formed of a non-transparent material, and therefore, it is preferred in improving conversion efficiency.

### (Fourth Embodiment)

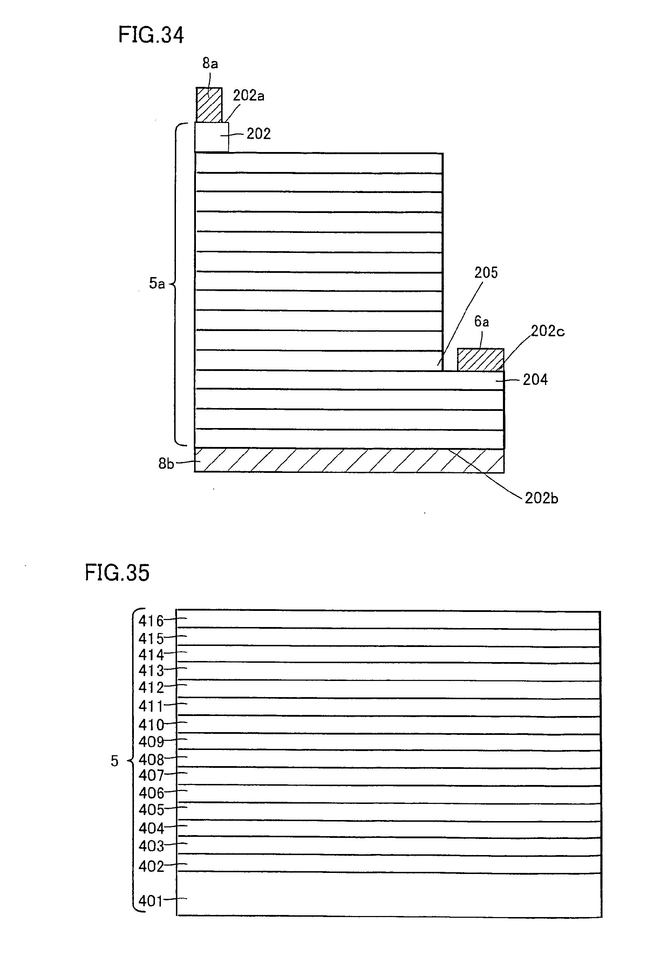

Fig. 34 is a schematic cross-section of a further example of the solar cell in accordance with the present invention. Here, the solar cell includes a first compound semiconductor stacked body 5a including an n-type compound semiconductor layer and a p-type compound semiconductor layer in contact with each other, a first electrode 8a formed on a first surface 202a of the first compound semiconductor stacked body 5a, a second electrode 6b formed on a second surface 202c exposed to the same side as the first surface 202a, and a third electrode 8b having a flat surface, formed on a third surface 202b that is opposite to the first surface 202a, of the first compound semiconductor stacked body 5a.

Here, the surfaces of the first and second electrodes 8a and 6a are exposed to the same side (upper side of the sheet of Fig. 34). Further, the first and second electrodes 8a and 6a are of mutually different polarities, that is either positive or negative.

Further, a tunnel junction is formed between compound semiconductor layer 202 on which the first electrode 8a is formed and compound semiconductor layer 204 on which the second electrode 6a is formed.

By such a structure, it becomes possible to form the first and second electrodes 8a and 6a on the surfaces of the compound semiconductor layers of the same conductivity type in the same direction. Therefore, the first and second electrodes 8a and 6a can be formed at the same time by the same material. Thus, the process of manufacturing the first and second electrodes 8a and 6a can be simplified.

In the solar cell having such a structure, when the wiring member is connected to the first and second electrodes 8a and 6a, it is unnecessary to invert the fist compound semiconductor stacked body 5a. The wiring member can be connected to each of the first and second electrodes 8a and 6a with the first compound semiconductor stacked body 5a placed on the stage. Therefore, even when the solar cell of the present invention is pressed by the electrode for welding, damage and crack of the solar cell of the present invention can be suppressed as compared with the conventional example.

Though the tunnel junction may be provided in the first compound semiconductor stacked body 5a, it is preferably formed at an interface between the compound semiconductor layer 205 having different conductivity from compound semiconductor layer 204 on which the second electrode 6a is formed and the compound semiconductor layer 204 on which the second electrode 6a is formed.

When the tunnel junction is formed at the interface between compound semiconductor layer 205 and compound semiconductor layer 204 where the second electrode 6a is formed, compound semiconductor layers 205 and 204 have high carrier concentration, and therefore, electric resistance of compound semiconductor layer 204 can be made low. In the solar cell shown in Fig. 34, a current generated in the first compound semiconductor layer 5a flows in the direction of the plane of compound semiconductor layer 204, and collected to the second electrode 6a. Therefore, by lowering the electric resistance of compound semiconductor layer 204, series resistance can be reduced.

It is preferred that the first and second surfaces 202a and 202c of the first compound semiconductor stacked body 5a are formed of one same material. In the step of forming the electrodes in which the first and second electrodes 8a and 6a are formed simultaneously using the same material, if the first and second surfaces 202a and 202c as the underlying layers for forming the first and second electrodes 8a and 6a are formed of the same material, the conditions of process steps that can reduce contact resistance would be the same, and therefore, selection of condition becomes easier.

Further, in the present invention, the third electrode 8b may not be formed. However, if the third electrode 8b is formed as described above, part of the current generated in the first compound semiconductor stacked body 5a can be collected through the third electrode 8b of low electric resistance to the second electrode 6a, and therefore, the series resistance at portions where the current flows can be reduced.

### [Examples]

### (Example 1)

First, as the substrate for epitaxial growth, an n-type GaAs substrate (1 x 10¹⁸ cm⁻³, Si doped, diameter: 100mm) was prepared. Then, the n-type GaAs substrate was put in a vertical MOCVD apparatus. As shown in Fig. 1, on a surface of n-type GaAs substrate 50, an n-type InGaP layer 51 having the thickness of about 0.5 µm was epitaxially grown as an intermediate layer.

Then, on a surface of n-type InGaP layer 51, an n-type GaAs layer 52 as an n-type cap layer, an n-type AlInP layer 53 as a window layer, an n-type InGaP layer 54 as an emitter layer, a p-type InGaP layer 55 as a base layer and a p-type AlInP layer 56 as a back surface electric field layer were epitaxially grown successively.

Thereafter, on a surface of p-type AlInP layer 56, a p-type AlGaAs layer 57 and an n-type InGaP layer 58 were epitaxially grown successively, to form a tunnel junction.

On n-type InGaP layer 58, an n-type AlInP layer 59 as a window layer, an n-type GaAs layer 60 as an emitter layer, a p-type GaAs layer 61 as a base layer, a p-type InGaP layer 62 as a back surface electric field layer, and a p-type GaAs layer 63 as a p-type cap layer were epitaxially grown successively. Consequently, a compound semiconductor stacked body 5 was formed. As a condition for epitaxial growth, the temperature was set to about 700 °C.

As materials for growing the GaAs layers, TMG (trimethyl gallium) and AsH₃ (arsine) were used. As materials for growing InGaP layers, TMI (trimethyl indium), TMG and PH₃ (phosphine) were used. As materials for growing AlInP layers, TMA (trimethyl aluminum), TMI and PH₃ were used.

Further, as an impurity material for forming the n-type GaAs layer, n-type InGaP layer and n-type AlInP layer, SiH₄ (mono-silane) was used. As an impurity material for forming the p-type GaAs layer, p-type InGaP layer and p-type AlInP layer, DEZn (diethyl zinc) was used.

Further, as materials for growing the AlGaAs layer, TMA, TMG and AsH₃ were used, and as an impurity material for forming the p-type AlGaAs layer, CBr₄ (carbon tetrabromide) were used.

Next, on a surface of p-type GaAs layer 63, an Au-Zn film was vapor-deposited, and a prescribed heat treatment was performed. Next, on a surface of the Au-Zn film, an Au plating film having the thickness of about 5 µm was formed. Consequently, on the surface of p-type GaAs layer 63, a back surface electrode layer 6 was formed, as shown in Fig. 2. As compared with the front surface electrode that will be described later, it is unnecessary to consider entrance of sunlight, and therefore, the back surface electrode layer 6 was formed on the entire surface of p-type GaAs layer 63. As back surface electrode layer 6 was formed on the entire surface of p-type GaAs layer 63, the surface of back surface electrode layer 6 became flat.

Thereafter, wax 7 was applied to the surface of back surface electrode layer 6, for protection, as shown in Fig. 3. In this state, n-type GaAs substrate 50 was dipped in ammonia water, to remove n-type GaAs substrate 50, as shown in Fig. 4. Here, the n-type GaAs substrate 50 having the thickness of about 350 µm was completely removed by etching, as it was kept dipped in the ammonia water for about 300 minutes. Etching was stopped when n-type InGaP layer 51 as the intermediate layer was exposed.

Then, by etching using an acid solution, the exposed n-type InGaP layer 51 as the intermediate layer was removed, and n-type GaAs layer 52 was exposed as shown in Fig. 5. Next, by photolithography, on the exposed surface of n-type GaAs layer 52, a prescribed resist pattern was formed.

Then, to cover the resist pattern, an Au film (containing Ge of 12 % by weight) was formed to the thickness of about 100 nm by resistance heating. Thereafter, by the EB vapor deposition, an Ni film having the thickness of about 20 nm and an Au film having the thickness of about 5000 nm were formed successively. Next, by the lift-off method, the resist pattern, the Au film formed on the resist pattern, the Ni film formed on the Au film, and the Au film formed on the Ni film were removed. In this manner, a surface electrode layer 8 was formed as shown in Fig. 6. Then, wax 7 was removed.

Next, using surface electrode layer 8 as a mask, etching with an alkali solution was performed, to remove exposed portions of n-type GaAs layer 52 where surface electrode layer 8 was not formed. Thereafter, a prescribed resist pattern was formed to cover surface electrode layer 8. Using the resist pattern as a mask, a part of compound semiconductor stacked body 5 was etched with an alkali solution and with an acid solution, so that an exposed portion was formed by exposing part of back surface electrode layer 6. In this manner, on the surface of back surface electrode layer 6, compound semiconductor stacked body 5 was divided into a plurality of pieces.

Further, by the EB vapor deposition method, a TiO₂ film having the thickness of about 55 nm and an MgF₂ film having the thickness of about 100 nm were formed continuously, as an anti-reflection film, on the side where the sunlight enters (surface of n-type AlInP layer 53). Thereafter, by cutting back surface electrode layer 6 along the exposed back surface electrode layer 6, two solar cells having the structure shown in Fig 7 were formed. Here, solar cell 2 had a rectangular shape with the width of 32 mm and length of 64 mm. The surface of exposed portion 6b of the second electrode 6a and the surface of the third electrode 8b were both rectangular, each having the size of about 1 mm in width and about 3 mm in length.

The two solar cells formed in the above-described manner were electrically connected by welding of first wiring member 10a and second wiring member 10b, respectively, as shown in Fig. 10, whereby a solar cell string was formed. Here, as the first and second wiring members 10a and 10b, a silver ribbon was used, which had the thickness of about 25 µm.

Welding of the first and second wiring members 10a and 10b was performed in the following manner. Specifically, a step of applying a load of about 1 kg to a tip end (having the size of 0.5 mm x 1 mm) of a molybdenum (Mo) electrode as the electrode for welding, and welding with a current of 0.5 kA, voltage of 1.1 V for a conduction time of 1/60 sec. was repeated for 15 cycles, as one welding operation, and for each connection between the wiring member and each electrode, five portions were welded.

Thereafter, as shown in Fig. 13, the solar cell string formed in the above-described manner was sandwiched between a film 11 and a transparent film 12, and a prescribed transparent adhesive 13 was filled. Thus, the solar cell string in accordance with Example 1 was finished.

Then, characteristics of the solar cell string in accordance with Example 1 were evaluated by a solar simulator. The solar simulator refers to an irradiation light source used for conducting indoor characteristics test and reliability test of solar cells, and in accordance with the object of testing, irradiation intensity, uniformity and spectrum conformity are set to satisfy the requirements.

First, as a reference light source, reference sunlight having air mass (AM) of 0 was used. The current-voltage characteristic of the solar cell string in accordance with Example 1 irradiated with the reference sunlight was measured.

Based on the measured current-voltage characteristic, short-circuit current Isc, open circuit voltage Voc, fill factor FF and conversion efficiency Eff were calculated. As a result, short-circuit current Isc was 340 mA, open circuit voltage Voc was 4.8 V, fill factor FF was 0.82 and conversion efficiency Eff was 23.7 %, and hence, it was confirmed that the solar cell string in accordance with Example 1 had satisfactory characteristics.

### (Example 2)

First, by epitaxially growing the following compound semiconductor layers on a p-type Ge substrate, a compound semiconductor stacked body 5 shown in the schematic cross-section of Fig. 16 was formed. Specifically, first, on a disk-shaped p-type Ge substrate 101 having the diameter of 50 mm doped with Ga, an n-type GaAs layer 103 having the thickness of 3 µm was formed as a buffer layer. At this time, an n-type Ge layer 102 having the thickness of 0.5 µm was formed at the surface of p-type Ge substrate 101, as As in the n-type GaAs layer 103 was diffused into p-type Ge substrate 101. Next, on n-type GaAs layer 103, an n-type InGaP layer 104 having the thickness of 0.02 µm was formed, and on n-type InGaP layer 104, a p-type AlGaAs layer 105 having the thickness of 0.02 µm was formed. Here, n-type InGaP layer 104 and p-type AlGaAs layer 105 form a tunnel junction.

Thereafter, on p-type AlGaAs layer 105, a p-type InGaP layer 106 having the thickness of 0.1 µm was formed as a back surface electric field layer, and on p-type InGaP layer 106, a p-type GaAs layer 107 having the thickness of 3 µm was formed as a base layer. Then, on p-type GaAs layer 107, an n-type GaAs layer 108 having the thickness of 0.1 µm was formed as an emitter layer, and on n-type GaAs layer 108, an n-type AlInP layer 109 having the thickness of 0.03 µm was formed as a window layer. Thereafter, on n-type AlInP layer 109, an n-type InGaP layer 110 having the thickens of 0.02 µm was formed, and on n-type InGaP layer 110, a p-type AlGaAs layer 111 having the thickness of 0.02 µm was formed. Here, n-type InGaP layer 110 and p-type AlGaAs layer 111 form a tunnel junction.

Then, on p-type AlGaAs layer 111, a p-type AlInP layer 112 having the thickness of 0.03 µm was formed as a back surface electric field layer, and on p-type AlInP layer 112, a p-type InGaP layer 113 having the thickness of 0.5 µm was formed as a base layer. Then, on p-type InGaP layer 113, an n-type InGaP layer 114 having the thickness of 0.05 µm was formed as an emitter layer, and on n-type InGaP layer 114, an n-type AlInP layer 115 was formed as a window layer. Thereafter, on n-type AlInP layer 115, an n-type GaAs layer 116 having the thickness of 0.5 µm was formed as the cap layer. In this manner, the compound semiconductor stacked body 5 shown in the schematic cross-section of Fig. 16 was formed.

As the condition for epitaxial growth described above, the temperature was set to about 700 °C. Further, as materials for growing the GaAs layers, TMG and AsH₃ were used. As materials for growing the InGaP layers, TMI, TMG and PH₃ were used. As materials for growing the AlInP layers, TMA, TMI and PH₃ were used.

As an impurity material for forming each of the n-type GaAs layer, n-type InGaP layer and n-type AlInP layer, SiH₄ was used. As an impurity material for forming each of the p-type GaAs layer, p-type InGaP layer and p-type AlInP layer, DEZn was used.

Further, as a material for growing the AlGaAs layer, TMA, TMG and AsH₃ were used, and as an impurity material for forming the p-type AlGaAs layer, CBr₄ was used.

Next, as shown in the schematic cross-section of Fig. 17, a part of n-type GaAs layer 116 was removed to a prescribed pattern by using an ammonia-based etchant. On a surface of the remaining n-type GaAs layer 116, an Au-Ge film having the thickness of 100 nm, an Ni film having the thickness of 20 nm, an Au film having the thickness of 100 nm and an Ag film having the thickness of 5000 nm were successively formed and heat treatment was performed, so that the first electrode 8a was formed as shown in the schematic cross-section of Fig. 18.

Next, as shown in the schematic cross-section of Fig. 19, a part of compound semiconductor stacked body 5 was.removed by an ammonia-based etchant and an HCl-based etchant, to a prescribed shape until the surface of p-type Ge substrate 101 was exposed. Then, on the exposed surface of p-type Ge substrate 101, an Au film having the thickness of 30 nm and an Ag film having the thickness of 5000 nm were successively vapor-deposited and heat-treated, so that the second electrode 6a was formed as shown in the schematic cross-section of Fig. 20. Though not shown, on the surface of n-type AlInP layer 115, a TiO₂ film having the thickness of 55 nm and an Al₂O₃ film having the thickness of 85 nm were formed successively as an anti-reflection film.

Then, the p-type Ge substrate 101 having the diameter of 50 mm was cut into a plurality of rectangular plates having the width of 20 mm and the length of 20mm, whereby a plurality of first compound semiconductor stacked bodies 5a were formed.

Thereafter, as shown in the schematic cross-section of Fig. 21, at prescribed positions of the first and second electrodes 8a and 6a, an Ag ribbon having the length of 10 mm, width of 3 mm and thickness of 0.03 mm as wiring member 10 was electrically connected by welding.

Thereafter, as shown in the schematic cross-section of Fig. 22, transparent adhesive 13 of silicone was applied to a surface of the sunlight entering side of first compound semiconductor stacked body 5a, transparent protective member 121 of glass having the thickness of 100 µm was adhered thereto, and transparent adhesive 13 was cured at a prescribed temperature, to fix the transparent protective member 121.

Thereafter, the surface of transparent protective member 121 was covered by a resist, and the thickness of p-type Ge substrate 101 was reduced by etching using a hydrofluoric acid-based etchant, to the thickness of 20 µm. Then, on the surface of p-type Ge substrate 101 thus made thin, an Au film having the thickness of 30 nm and an Ag film having the thickness of 3000 nm were successively vapor-deposited and thereafter heat-treated, so that the third electrode 8b shown in the schematic cross-section of Fig. 23 was formed, and the solar cell in accordance with Example 2 was finished. Here, it was confirmed by resistance measurement by a tester that the resistance between the second and third electrodes 6a and 8b was at most 1 Ω.

The characteristics of the solar cell in accordance with Example 2 were evaluated using the solar simulator, in the similar manner as Example 1. As a result, short-circuit current Isc was 17 mA, open circuit voltage Voc was 2.5 V, fill factor FF was 0.85 and conversion efficiency Eff was 26.3 %. Therefore, it was confirmed that the solar cell in accordance with Example 2 had satisfactory characteristics.

### (Example 3)

First, on a p-type Ge substrate, the following compound semiconductor single crystal layers were epitaxially grown successively, to form compound semiconductor stacked body 5 shown in the schematic cross-section of Fig. 24. Specifically, first, on a disk-shaped p-type Ge substrate 125 having the diameter of 50 mm doped with Ga, a p-type GaAs layer 126 having the thickness of 3 µm was formed as a buffer layer. Thereafter, on p-type GaAs layer 126, a p-type InGaP layer 127 having the thickness of 0.02 µm was formed, and on p-type InGaP layer 127, a p-type AlGaAs layer 128 having the thickness of 0.02 µm was formed.

Thereafter, on p-type AlGaAs layer 128, a p-type AlInP layer 129 having the thickness of 0.03 µm was formed as a back surface electric field layer, and on p-type AlInP layer 129, a p-type InGaP layer 130 having the thickness of 0.5 µm was formed as a base layer. Then, on p-type InGaP layer 130, an n-type InGaP layer 131 having the thickness of 0.05 µm was formed as an emitter layer, and on n-type InGaP layer 131, an n-type AlInP layer 132 having the thickness of 0.03 µm was formed as a window layer. Thereafter, on n-type AlInP layer 132, an n-type GaAs layer 133 having the thickness of 0.5 µm was formed as a cap layer. In this manner, compound semiconductor stacked body 5 shown in the schematic cross-section of Fig. 24 was formed.

As the condition for epitaxial growth described above, the temperature was set to about 700 °C. Further, as materials for growing the GaAs layers, TMG and AsH₃ were used. As materials for growing the InGaP layers, TMI, TMG and PH₃ were used. As materials for growing the AlInP layers, TMA, TMI and PH₃ were used.

As an impurity material for forming each of the n-type GaAs layer, n-type InGaP layer and n-type AlInP layer, SiH₄ was used. As an impurity material for forming each of the p-type GaAs layer, p-type InGaP layer and p-type AlInP layer, DEZn was used.

Further, as a material for growing the AlGaAs layer, TMA, TMG and AsH₃ were used, and as an impurity material for forming the p-type AlGaAs layer, CBr₄ was used.

Next, as shown in the schematic cross-section of Fig. 25, a part of n-type GaAs layer 133 was removed by an ammonia-based etchant to a prescribed pattern. On the surface of the remaining n-type GaAs layer 133, an Au-Ge film having the thickness of 100 nm, an Ni film having the thickness of 20 nm, an Au film having the thickness of 100 nm and an Ag film having the thickness of 5000 nm were successively vapor-deposited and thereafter heat-treated, whereby the first electrode 8a was formed as shown in the schematic cross-section of Fig. 26.

Then, as shown in the schematic cross-section of Fig. 27, a part of the compound semiconductor stacked body 5 was removed using an ammonia-based etchant and an HCl-based etchant, to a prescribed pattern until the surface of p-type AlGaAs layer 128 was exposed. On the exposed surface of p-type AlGaAs layer 128, an Au film having the thickness of 30 nm and an Ag film having the thickness of 5000 nm were successively vapor-deposited and then heat-treated, whereby the second electrode 6a was formed, as show in the schematic cross-section of Fig. 28. Though not shown, on the surfaces of n-type AlInP layer 132 and p-type AlGaAs layer 128, a TiO₂ film having the thickness of 55 nm and an Al₂O₃ film having the thickness of 85 nm were successively formed as an anti-reflection film.

Thereafter, p-type Ge substrate 125 having the diameter of 50 mm was cut into a plurality of rectangular plates having the width of 20 mm and the length of 20mm, whereby a plurality of first compound semiconductor stacked bodies 5a were formed.

Thereafter, as shown in the schematic cross-section of Fig. 29, at prescribed positions of the first and second electrodes 8a and 6a, an Ag ribbon having the length of 10 mm, width of 3mm and thickness of 0.03 mm as wiring member 10 was electrically connected by welding.

Thereafter, as shown in the schematic cross-section of Fig. 30, transparent adhesive 13 of silicone was applied to a surface of the sunlight entering side of first compound semiconductor stacked body 5a, transparent protective member 121 of glass having the thickness of 100 µm was adhered thereto, and transparent adhesive 13 was cured at a prescribed temperature, to fix the transparent protective member 121.

Thereafter, the surface of transparent protective member 121 was covered by a resist, and p-type Ge substrate 125 and p-type GaAs layer 126 were removed by etching using a hydrofluoric acid-based etchant, and etching was stopped when the surface of p-type InGaP layer 127 was exposed, as shown in the schematic cross-section of Fig. 31.

Then, as shown in the schematic cross-section of Fig. 32, on the exposed surface of p-type InGaP layer 127, an Au film having the thickness of 30 nm and an Ag film having the thickness of 5000 nm patterned by a metal mask were successively vapor-deposited and then heat-treated, whereby the third electrode 8b in a lattice shape was formed. Here, the third electrode 8b covered 10 % of the exposed surface of p-type InGaP layer 127. Further, it was confirmed by resistance measurement by a tester that the resistance between the second and third electrodes 6a and 8b was at most 1 Ω.

Further, as shown in the schematic cross-section of Fig. 33, on the surface opposite to the sunlight entering side of first compound semiconductor stacked body 5a, transparent adhesive 13 of silicone is applied, and a back surface electrode type solar cell 137 having n-type impurity diffused Si layer 135 and p-type impurity diffused layer 136 formed alternately on a surface opposite to the sunlight entering side of n-type Si substrate 134 was adhered, and transparent adhesive 13 was cured at a prescribed temperature, so that the solar cell in accordance with Example 3 was formed. Here, on n-type impurity diffused Si layer 135, an n-electrode 138 was formed, and on p-type impurity diffused Si layer 136, a p-electrode 139 was formed. Further, an Ag ribbon as a wiring member 10 was connected as a wire to n-electrode 138, and an Ag ribbon as a wiring member 10 was connected as a wire to p-electrode 139.

The characteristics of the solar cell in accordance with Example 3 were evaluated using the solar simulator, in the similar manner as Example 1. As a result, short-circuit current Isc was 21 mA, open circuit voltage Voc was 2.1 V, fill factor FF was 0.85 and conversion efficiency Eff was 27.2 %. Therefore, it was confirmed that the solar cell in accordance with Example 3 had satisfactory characteristics. (Example 4)

First, as shown in the schematic cross-section of Fig. 35, on a disk-shaped n-type GaAs substrate 401 having the diameter of 50 mm doped with Si, an n-type GaAs layer 402 having the thickness of 3 µm as a buffer layer, an n-type InGaP layer 403 having the thickness of 0.02 µm as a buffer layer, an n-type GaAs layer 404 having the thickness of 0.02 µm, a p-type AlGaAs layer 405 having the thickness of 0.02 µm, a p-type InGaP layer 406 having the thickness of 0.1 µm as a back surface electric field layer, a p-type GaAs layer 407 having the thickness of 3 µm as a base layer, an n-type GaAs layer 408 having the thickness of 0. 1 µm as an emitter layer, and an n-type AlInP layer 409 having the thickness of 0.03 µm as a window layer were epitaxially grown successively. Here, n-type GaAs layer 404 and p-type AlGaAs layer 405 form a tunnel junction. Further, p-type GaAs layer 407 and n-type GaAs layer 408 in contact with each other function as a photo-electric conversion layer.

Thereafter, on n-type AlInP layer 409, an n-type InGaP layer 410 having the thickness of 0.02 µm, a p-type AlGaAs layer 411 having the thickness of 0.02 µm, and a p-type AlInP layer 412 having the thickness of 0.03 µm as a back surface electric field layer were formed, and a p-type InGaP layer 413 having the thickness of 0. 5 µm as a base layer, an n-type InGaP layer 414 having the thickness of 0.05 µm as an emitter layer, an n-type AlInP layer 415 having the thickness of 0.03 µm as a window layer and an n-type GaAs layer 416 having the thickness of 0.5 µm as a cap layer were epitaxially grown successively. Consequently, compound semiconductor stacked body 5 was formed. Here, n-type InGaP layer 410 and p-type AlGaAs layer 411 form a tunnel junction. Further, p-type InGaP layer 413 and n-type InGaP layer 414 in contact with each other function as a photo-electric conversion layer.

As the condition for epitaxial growth described above, the temperature was set to about 700°C. Further, as materials for growing the GaAs layers, TMG and AsH₃ were used. As materials for growing the InGaP layers, TMI, TMG and PH₃ were used. As materials for growing the AlInP layers, TMA, TMI and PH₃ were used.

As an impurity material for forming each of the n-type GaAs layer, n-type InGaP layer and n-type AlInP layer, SiH₄ was used. As an impurity material for forming each of the p-type GaAs layer, p-type InGaP layer and p-type AlInP layer, DEZn was used.

Further, as a material for growing the AlGaAs layer, TMA, TMG and AsH₃ were used, and as an impurity material for forming the p-type AlGaAs layer, CBr₄ was used.

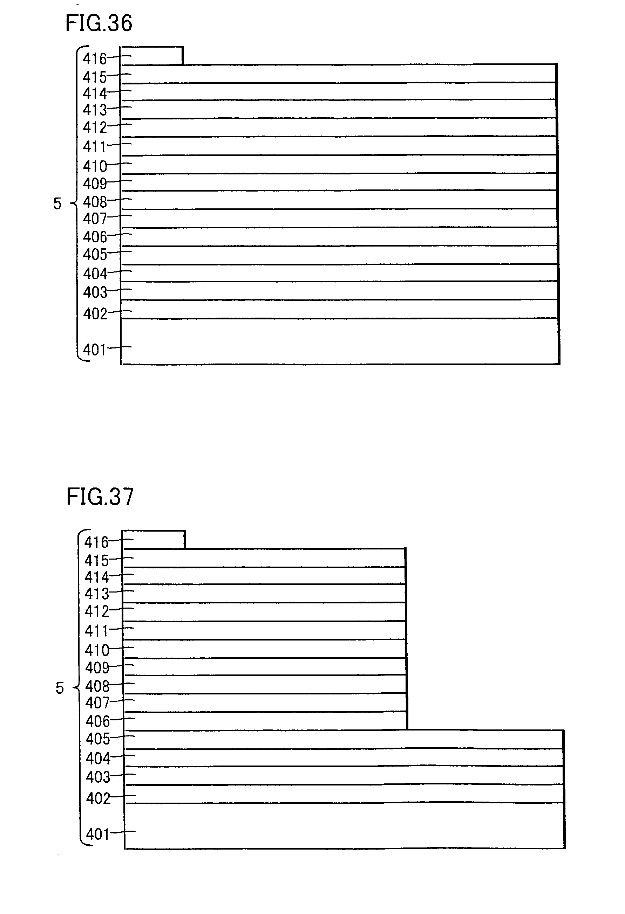

Next, a resist was applied to the entire surface of n-type GaAs layer 416, photolithography was performed to leave a part of the resist, and n-type GaAs layer 416 at portions where the resist was not left was removed to a prescribed pattern by using an ammonia-based etchant, as shown in the schematic cross-section of Fig. 36. Then, the resist was fully removed.

Next, a resist was again applied to the entire surfaces of n-type GaAs layer 416 and n-type AlInP layer 415, and the resist corresponding to portions of removal of compound semiconductor stacked body 5 was removed.

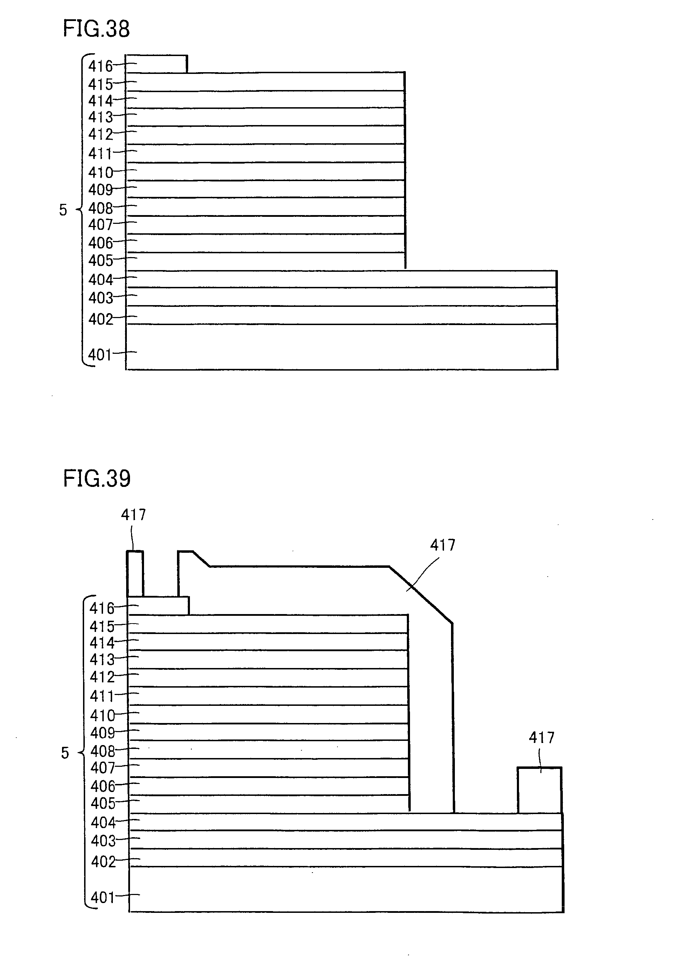

Thereafter, as shown in the schematic cross-section of Fig. 37, a part of compound semiconductor stacked body 5 was removed by an ammonia-based etchant and an HCl-based etchant to a prescribed pattern, until the surface of p-type AlGaAs layer 405 was exposed. Then, as shown in the schematic cross-section of Fig. 38, by an HCl-based etchant, the exposed p-type AlGaAs layer 405 was removed. Thus, the surface of n-type GaAs layer 404 was exposed.

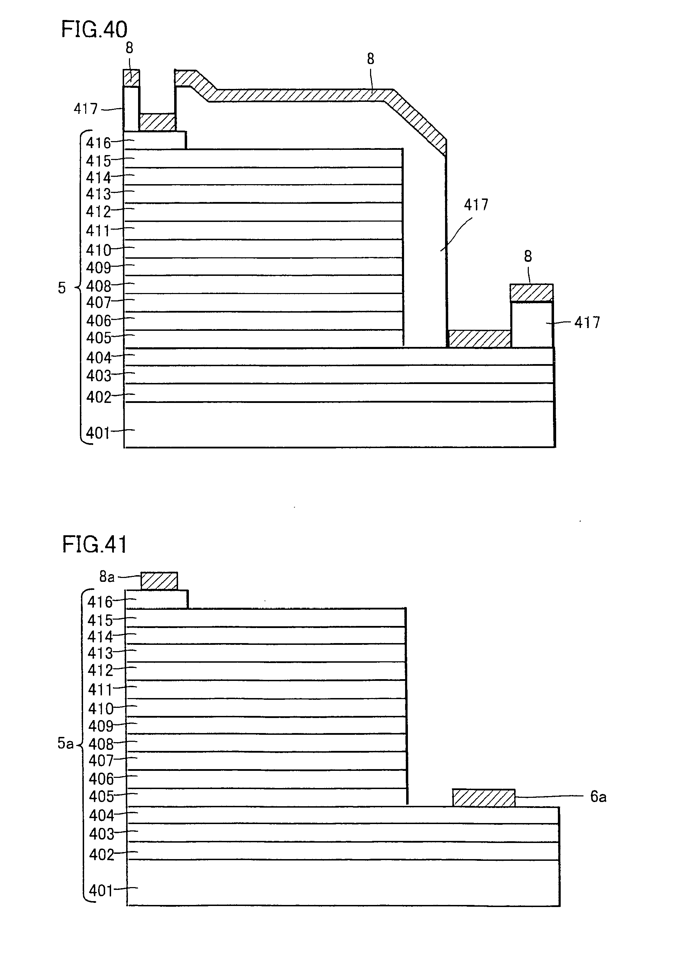

Then, as shown in the schematic cross-section of Fig. 39, a resist was applied to the entire surface of compound semiconductor stacked body 5, and a part of the resist was removed by photolithography, so that a resist pattern 417 was formed. Next, as shown in the schematic cross-section of Fig. 40, from above the resist pattern 417, an Au-Ge film having the thickness of 100 nm, an Ni film having the thickness of 20 nm, an Au film having the thickness of 100 nm and an Ag film having the thickness of 5000 nm were vapor-deposited successively, whereby surface electrode layer 8 was formed.

Thereafter, by the lift-off method, a part of the surface electrode layer 8 formed on resist pattern 417 was removed together with resist 417, and thereafter, heat treatment was performed. Consequently, the first and second electrodes 8a and 6a shown in the schematic cross-section of Fig. 41 were formed simultaneously. Then, the n-type GaAs substrate 401 having the diameter of 50 mm was cut into a plurality of rectangular plates having the width of 20 mm and the length of 20mm, whereby compound semiconductor stacked body 5 was divided into the first compound semiconductor stacked bodies 5a shown in Fig. 41.

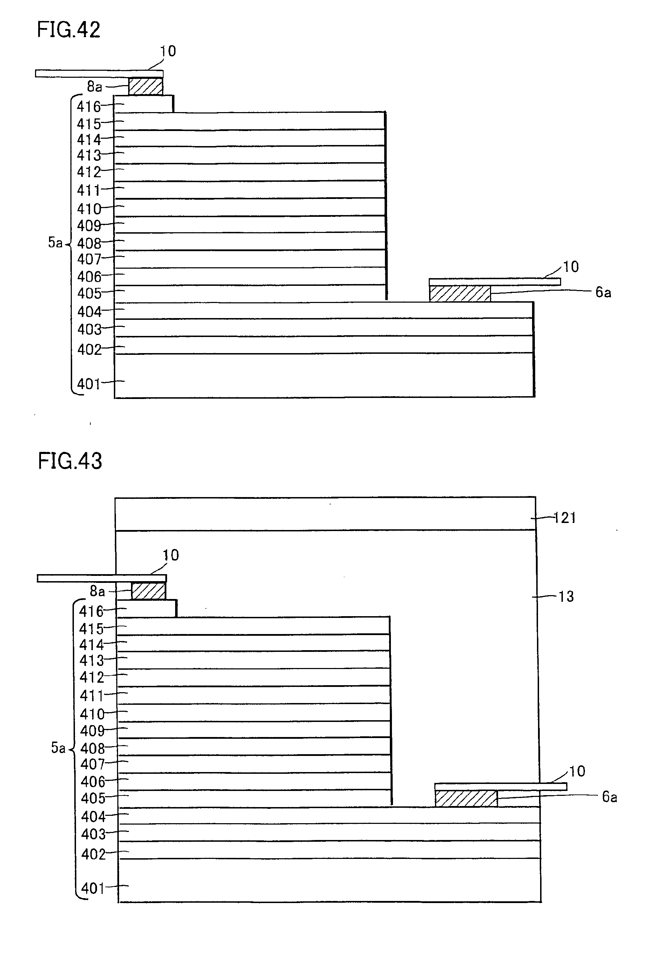

Thereafter, as shown in the schematic cross-section of Fig. 42, to first and second electrodes 8a and 6a, an Ag ribbon having the length of 10 mm, width of 3mm and thickness of 0.03 mm as wiring member 10 was electrically connected by welding. Then, on the surface of n-type AlInP layer 415, a TiO₂ film having the thickness of 55 nm and an Al₂O₃ film having the thickness of 85 nm were successively vapor-deposited as an anti-reflection film.

Then, as shown in the schematic cross-section of Fig. 43, on the surface of first compound semiconductor stacked body 5a, transparent adhesive 13 of silicone was applied, transparent protective member 121 of glass having the thickness of 100 µm was adhered thereto, and transparent adhesive 13 was cured at a prescribed temperature, to fix the transparent protective member 121.

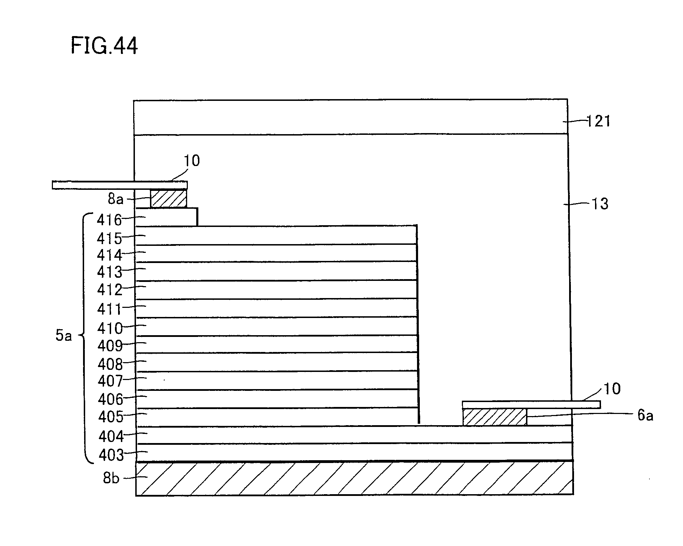

Thereafter, the surface of transparent protective member 121 was covered by a resist, and n-type GaAs substrate 401 and n-type GaAs layer 402 were removed by an ammonia-based etchant. Then, on the exposed surface of n-type InGaP layer 403, an Au film having the thickness of 30 nm and an Ag film having the thickness of 3000 nm were vapor-deposited successively and then heat-treated, to form the third electrode 8b on the entire exposed surface of n-type InGaP layer 403, whereby the solar cell of Example 4 shown in the schematic cross-section of Fig. 44 was formed.

The characteristics of solar cell of Example 4 were evaluated by a solar simulator under the same condition as Example 1 except that air mass (AM) was set to 1.5. As a result, short-circuit current Isc was 39 mA, open circuit voltage Voc was 2.47 V, fill factor FF was 0.83 and conversion efficiency Eff was 20 %. Therefore, it was confirmed that the solar cell in accordance with Example 4 had satisfactory characteristics. Further, in manufacturing the solar cell of Example 4, the first and second electrodes 8a and 6a could be formed simultaneously, and therefore, the steps of forming the electrodes could be simplified.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A solar cell (2, 2a, 2b), comprising a first compound semiconductor stacked body (5a) including an n-type compound semiconductor layer and a p-type compound semiconductor layer in contact with each other; wherein said first compound semiconductor stacked body (5a) has a first electrode (8a) of a first polarity and a second electrode (6a) of a second polarity; and a surface of said first electrode (8a) and a surface of said second electrode (6a) are exposed to the same side.

2. A solar cell string (1), comprising a plurality of solar cells (2, 2a, 2b) according to claim 1, wherein said second electrode (6a) of a first said solar cell (2, 2a, 2b) is electrically connected by a first wiring member (10a) to said first electrode (8a) of a second said solar cell (2, 2a, 2b).

3. A method of manufacturing a solar cell string (1) by electrically connecting a plurality of solar cells (2, 2a, 2b) according to claim 1 with each other, comprising the steps of: placing a first said solar cell (2, 2a, 2b) and a second said solar cell (2, 2a, 2b) on a stage (21) each with a side where a surface of said first electrode (8a) is exposed facing upward; electrically connecting one end of a first wiring member (10a) to said second electrode (6a) of the first said solar cell (2, 2a, 2b); and electrically connecting the other end of said first wiring member (10a) to said first electrode (8a) of the second said solar cell (2, 2a, 2b).

4. The method of manufacturing a solar cell string (1) according to claim 3, wherein a metal ribbon or a metal wire is used as said first wiring member (10a), and said first wiring member (10a) is connected by welding or bonding.

5. The solar cell (2, 2a, 2b) according to claim 1, further comprising a second compound semiconductor stacked body (5b) including an n-type compound semiconductor layer and a p-type compound semiconductor layer in contact with each other, provided spaced apart from said first compound semiconductor stacked body (5a); wherein a third electrode (8b) is provided on a surface of said second compound semiconductor stacked body (5b).

6. A solar cell string (1), comprising a plurality of solar cells (2, 2a, 2b) according to claim 5, wherein said second electrode (6a) of a first said solar cell (2, 2a, 2b) is electrically connected by a first wiring member (10a) to said first electrode (8a) of a second said solar cell (2, 2a, 2b), and said third electrode (8b) of the first said solar cell (2, 2a, 2b) is electrically connected by a second wiring member (10b) to said second electrode (6b) of the second said solar cell (2, 2a, 2b).

7. A method of manufacturing a solar cell string (1) by electrically connecting a plurality of solar cells (2, 2a, 2b) according to claim 5 with each other, comprising the steps of: placing a first said solar cell (2, 2a, 2b) and a second said solar cell (2, 2a, 2b) on a stage (21) each with a side where a surface of said first electrode (8a) is exposed facing upward; electrically connecting one end of a first wiring member (10a) to said second electrode (6a) of the first said solar cell (2, 2a, 2b); electrically connecting the other end of said first wiring member (10a) to said first electrode (8a) of the second said solar cell (2, 2a, 2b); electrically connecting one end of a second wiring member (10b) to said third electrode (8b) of the first said solar cell (2, 2a, 2b); and electrically connecting the other end of said second wiring member (10b) to said second electrode (6a) of the second said solar cell (2, 2a, 2b).

8. The method of manufacturing a solar cell string (1) according to claim 7, wherein a metal ribbon or a metal wire is used as said first wiring member (10a) and said second wiring member (10b), and said first wiring member (10a) and said second wiring member (10b) are each connected by welding or bonding.

9. The solar cell (2, 2a, 2b) according to claim 1, wherein said first compound semiconductor stacked body (5a) has a third electrode (8b) of which surface is exposed to a side opposite to said first electrode (8a) and said second electrode (6a).

10. The solar cell (2, 2a, 2b) according to claim 9, wherein resistance between said second electrode (6a) and said third electrode (8b) is at most 1 Ω.

11. The solar cell (2, 2a, 2b) according to claim 9, wherein said third electrode (8b) is formed to have a lattice shape.

12. The solar cell (2, 2a, 2b) according to claim 9, wherein said third electrode (8b) is formed of a transparent conductive material.

13. The solar cell (2, 2a, 2b) according to claim 1, having a tunnel junction between said compound semiconductor layer on which said first electrode (8a) is formed and said compound semiconductor layer on which said second electrode (6a) is formed.

14. The solar cell (2, 2a, 2b) according to claim 13, wherein said tunnel junction is formed at an interface between a compound semiconductor layer having a different conductivity from said compound semiconductor layer on which said second electrode (6a) is formed and said compound semiconductor layer on which said second electrode (6a) is formed.
